# EUROPÄISCHE PATENTSCHRIFT

(11) **EP 3 149 799 B1**
(45) Veröffentlichungstag und Bekanntmachung des Hinweises auf die Patenterteilung: **06.05.2020**
(21) Anmeldenummer: 15722068.2
(22) Anmeldetag: 07.05.2015
(51) Int. Cl.: H01P 1/205, H05K 9/00

(54) **HOCHFREQUENZDICHTES GEHÄUSE, INSBESONDERE HOCHFREQUENZDICHTES FILTERGEHÄUSE**
HIGH-FREQUENCY SHIELDED HOUSING, IN PARTICULAR HIGH-FREQUENCY SHIELDED FILTER HOUSING
BOÎTIER BLINDÉ CONTRE LES HAUTES FRÉQUENCES, EN PARTICULIER BOÎTIER DE FILTRE BLINDÉ CONTRE LES HAUTES FRÉQUENCES

(30) Priorität: 27.05.2014 DE 102014007927
(43) Veröffentlichungstag der Anmeldung: 05.04.2017
(73) Patentinhaber: KATHREIN SE, 83022 Rosenheim (DE)
(72) Erfinder: GÖTTL, Maximilian, 83112 Frasdorf (DE); HAUNBERGER, Thomas, 83435 Bad Reichenhall (DE); STOLLE, Manfred, 83043 Bad Aibling (DE)
(74) Vertreter: Flach Bauer Stahl Patentanwälte Partnerschaft mbB
(86) Internationale Anmeldenummer: PCT/EP2015/000932
(87) Internationale Veröffentlichungsnummer: WO 2015/180820

(56) Entgegenhaltungen:
- EP-A2- 0 952 765
- US-A- 5 847 317
- US-A1- 2013 322 021
- US-A1- 2014 055 215
- US-B1- 6 307 449

## Beschreibung

Die Erfindung betrifft ein hochfrequenzdichtes Gehäuse nach dem Oberbegriff des Anspruches 1, insbesondere ein hochfrequenzdichtes Filtergehäuse.

In der Kommunikationstechnik, beispielsweise in der Rundfunk- und Fernseh-Übertragungstechnik sowie auf dem Gebiet der Mobilfunk-Kommunikation, kommt der Schirmung, hinsichtlich hochfrequenter Strahlung, von Geräten, Gehäusen, Boxen, Komponenten oder allgemein von Baugruppen eine große Bedeutung zu. Der Einfachheit halber wird oftmals auch nur von einer sogenannten hochfrequenzdichten Schirmung gesprochen. Es soll damit verhindert werden, dass hochfrequente Strahlung aus dem zu schirmenden Bereich (Gehäuse etc.) nach außen hinaustritt oder in den zu schirmenden Bereich (Gehäuse etc.) hineingelangt. Durch diese Maßnahmen sollen hochfrequente Störeinstrahlungen beiderseits vermieden werden, wobei die Effekte hier vielfältig sein können. Neben dem Einstrahlen von unerwünschten Signalkomponenten können auch sogenannte unerwünschte Intermodulationsprodukte entstehen. Eine entsprechende Schirmung kann auch innerhalb eines Gehäuses in Form von Trennwänden Anwendung finden, um zum Beispiel verschiedene Schaltungsteile einer Elektronik voneinander abzuschirmen.
Häufigste Ursache von elektromagnetischer Störstrahlung ist die mangelnde Ausführung der Verbindung von Gehäusewänden und entsprechenden Deckelteilen. Kleine Spalten, die wie Schlitzantennen wirken, können die Schirmdämpfung erheblich verringern. Diese Spalten entstehen durch schlechte Kontakte, Toleranzen oder durch Unregelmäßigkeiten bzw. Unebenheiten der Gehäusewände oder Deckeloberflächen.
Von daher weisen Schraub- oder Nietverbindungen auch große Nachteile auf, wenn diese Technik zur Verwirklichung einer hochfrequenzdichten Schirmung eingesetzt werden soll.
Zum Ausgleich von Unregelmäßigkeiten beispielsweise zwischen einem Deckel und einer Gehäusewand und zur Erzielung einer ausreichenden Schirmung sind bereits die unterschiedlichsten einzufügenden Dichtungselemente oder Kontaktstreifen verwendet worden.
Insbesondere in funktechnischen Anlagen wie beispielsweise im Mobilfunkbereich werden häufig Filter in unterschiedlichsten Ausbildungen eingesetzt, beispielsweise als Bandsperrfilter, als Bandpassfilter, als Hochpass- oder Tiefpassfilter etc.. Entsprechende Filter können auch als Duplex-Filter ausgebildet sein, die beispielsweise einen Sendezweig und einen Empfangszweig umfassen, der von verschiedenen Anschlüssen jeweils zu einem gemeinsamen Antennenanschluss führt. Zur Trennung der Sende- und Empfangssignale ist deshalb eine geeignete Frequenzfilterung erforderlich.

Derartige Hochfrequenz-Filter werden häufig in koaxialer Bauweise ausgebildet, also als so genannte koaxiale Resonatoren.

Unabhängig von dieser Bauform ist es notwendig, dass die entsprechenden Resonatoren, d.h. die Filtergehäuse hochfrequenzdicht geschirmt ausgebildet sind.

Ein Hochfrequenz-Filter ist beispielsweise aus der WO 2006/063640 A1 bekannt geworden. Dieses Hochfrequenz-Filter kann dabei aus einer Vielzahl von Resonatoren bestehen, die jeweils ein Außenleitergehäuse, einen Gehäuseboden sowie einen bevorzugt koaxial zum Außenleiter angeordneten Innenleiter umfassen, der in der Regel im Abstand unterhalb des auf das Gehäuse aufsetzbaren Gehäusedeckels endet.

Bekanntermaßen werden derartige Hochfrequenz-Filter, die nachfolgend auch kurz als HF-Filter bezeichnet werden, aus einem Metallgehäuse, üblicherweise einem Aluminiumgehäuse gefertigt. Sie können beispielsweise als Fräs- oder Gussteil ausgebildet sein, so dass möglichst keine Intermodulationsprobleme durch Stoßstellen im Filter auftreten. Zudem wird auch der Gehäusedeckel ebenfalls in der Regel aus einem Metall, d.h. einem Fräs- oder Gussteil gefertigt, beispielsweise aus Aluminium, wobei der Gehäusedeckel zur Erzielung einer guten elektrischen Kontaktfähigkeit mit dem Gehäuse zudem bevorzugt versilbert wird. Dabei ist grundsätzlich auch bekannt, dass beispielsweise das Gehäuse und/oder der Deckel aus einem Dielektrikum (Kunststoff) gebildet sein können/kann. In diesem Fall muss das Gehäuse bzw. der Deckel versilbert oder zumindest mit einer metallischen Schicht überzogen sein, um den Resonator-Innenraum hochfrequenzdicht abzuschließen. Dabei ist auch hier die kritische Stelle der galvanische Kontakt zwischen der Deckelunterseite und dem oben aufliegenden Rand des Hochfrequenz-Filtergehäuses.

Üblicherweise ist der Gehäusedeckel an seinem umlaufenden Rand mit einer Reihe von Bohrungen versehen, die mit entsprechenden Gewindebohrungen in den Gehäusewänden des Hohlraumfilters fluchten, so dass durch Eindrehen von Schrauben der Gehäusedeckel fest an dem eigentlichen Gehäuse angebracht werden kann, um hierdurch eine hochfrequenzdichte Montage des Deckels zu gewährleisten.

Von daher schlägt die gattungsbildende EP 2 443 694 B2 vor, als Deckel für ein HF-dichtes Filtergehäuse eine Leiterplatte zu verwenden, die aus einem entsprechenden Platinenmaterial besteht. Das Material einer derartigen Leiterplatte ist im Vergleich zu Metall zumindest geringfügig stärker verformbar. Dadurch soll ermöglicht werden, dass der aus einer Leiterplatte bestehende Deckel, der an seiner dem Gehäuse zugewandt liegenden Unterseite mit einer elektrisch leitfähigen metallisierten Schicht überzogen ist, möglichst gut an dem umlaufenden Rand des boxenförmigen Gehäuses aufliegt und beim Eindrehen von Schrauben entsprechend fest hieran anliegt. Dadurch soll gewährleistet werden, dass möglichst keine Intermodulationsprobleme entstehen. Alternativ hierzu kann ein solcher Deckel auch mit dem Gehäuse verlötet werden, um etwaige Spalte gänzlich zu verhindern.

Da also das Filtergehäuse stets mit einem Deckel verschlossen wird, erfordert dies aufgrund der Intermodulations-Anforderungen insbesondere im Mobilfunk eine plane Deckelauflage und definierte Kontaktdrücke. Um dies zu erreichen, ist eine sehr große Anzahl von Schrauben/ Kontaktpunkten erforderlich. Die Schrauben müssen im definierten (nicht zu großen) Abstand positioniert werden. Grund dafür ist die hohe Frequenz der Signale, bei der das Filter arbeitet. Sichergestellt werden muss zum einen eine entsprechend dichte Folge von Schraubverbindungen zur Fixierung des Deckels am Hochfrequenz-Filtergehäuse und zum anderen, dass zwischen dem Deckel und den Schrauben kein Spalt entsteht.

Nur der Vollständigkeit halber soll beispielsweise bezüglich der Ausgestaltung einer Filteranordnung mit mehreren Resonatoren auch auf die WO 88/01104 A1 verwiesen werden, die einen so genannten dielektrischen Block mit einer diesen dielektrischen Block übergreifenden Deckelanordnung umfasst, der an seinen Außenlängsseiten beabstandet zueinander elastisch vorgespannte Zungen aufweist. Diese Zungen sollen dann an der Außenseite des dielektrischen Blockes anliegen, der mit einer elektrisch leitfähigen Oberfläche versehen ist. Hierdurch soll eine galvanische Kontaktierung bewerkstelligt werden, die aber große Probleme bezüglich einer intermodulationsfesten Anordnung darstellt, weil keine eindeutig reproduzierbaren Bedingungen herstellbar sind.

Aus der US 2013/0322021 A1 ist ebenfalls ein HF-dichtes Gehäuse als bekannt zu entnehmen. Dieses Gehäuse soll von Hause aus Öffnungen zwischen dem umlaufenden Gehäuserand und dem Deckel aufweisen, um hier beispielsweise Wärme von innen nach außen abzuführen. Dazu werden in Umfangsrichtung des Gehäuserandes versetzt ausgebildete Vorsprünge vorgeschlagen, die auf der Deckelunterseite ausgebildet sind, mit denen also der Deckel am umlaufenden Stirnseitenrand des Gehäuses an versetzt zueinander liegenden Stellen aufliegt. Zwischen zwei derartigen Vorsprüngen ist dann mittig eine Bohrung im Deckel vorgesehen, um hier den Deckel mittels Schrauben an den Gehäusewänden zu befestigen. Die Schrauben können dabei so festgezogen werden, dass im Bereich der Schrauben der Gehäusedeckel ebenfalls an den Stirnseiten der eben umlaufenden Gehäusewand anliegt.

In einer dazu alternativen Variante können die entsprechenden versetzt zueinander liegenden Vorsprünge auch am umlaufenden Stirnseitenrand des Gehäuses ausgebildet sein. Wird ein ebener Deckel aufgelegt, so berührt er diese Vorsprünge. Zwischen zwei Vorsprüngen werden ebenfalls wieder die Schrauben durch Bohrungen im Deckel in die Gehäusewände eingedreht, wodurch auch in dieser Variante der Gehäusedeckel zwangsläufig im Bereich der Schraubenköpfe dann entsprechend in Richtung umlaufender Stirnseite der Gehäusewand durchbogen werden muss. Kontaktstellen sind dadurch immer im Bereich zwischen Deckel und Gehäusewand realisiert, an denen die Schrauben fest eingedreht sind. Weitere Kontaktstellen sind jeweils an den erhabenen Vorsprüngen zwischen Gehäusedeckel und Stirnseite der Gehäusewand gebildet.

Ein geschirmtes Gehäuse ist grundsätzlich auch aus der Vorveröffentlichung US 6,307,449 B1 als bekannt zu entnehmen. Das Gehäuse hat einen umlaufenden glatten Rand, auf welchem ein Gehäusedeckel aufgesetzt und in den Ecken mittels Schrauben befestigt wird. Zum Anschluss einer Platine kann an einer Seitenwand des Gehäuses eine entsprechend große Ausnehmung vorgesehen sein, durch die hindurch ein Substrat, beispielsweise in Form einer Platine, aus dem Gehäuse seitlich herausragen kann. Ein derartiges Gehäuse ist allerdings aufgrund der großen Öffnungen nicht mehr als elektromagnetisch dicht oder gar hochfrequenzmäßig elektromagnetisch dicht zu bezeichnen.

Hilfsmittel wie Kontaktstreifen zur Herstellung eines hochfrequenzdichten Gehäuses sind grundsätzlich auch aus der EP 0 952 765 A2 bekannt. Dort wird ein spezifischer Kontaktstreifen vorgeschlagen, der eine Vielzahl von schräg verlaufenden Kontaktfingern aufweist. Ein derartiger Kontaktstreifen kann dann in entsprechenden Ausnehmungen zwischen Gehäuse und Gehäusedeckel eingelegt werden, um eine möglichst dichte Kontaktfolge zwischen Gehäusedeckel und Gehäuse zu ermöglichen, wodurch die Hochfrequenzdichtigkeit hergestellt werden soll.

Demgegenüber ist es Aufgabe der vorliegenden Erfindung, ein verbessertes HF-dichtes Gehäuse und insbesondere HF-dichtes Filtergehäuse zu schaffen, welches neben dem eigentlichen, in der Regel boxenförmigen Gehäuse einen Deckel umfasst, der mittels Schraubverbindungen am Umfangsrand des Gehäuses mit dem Filtergehäuse fest verbunden wird. Dabei soll die Anordnung derart sein, dass mit geringstem Aufwand eine hochfrequenzdichte Verbindung geschaffen wird, die Intermodulationsprobleme vermeidet bzw. bis auf einen minimalen tolerierbaren Anteil verringert.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Im Rahmen der Erfindung wird eine überraschend einfache Lösung für ein hochfrequenzdichtes Gehäuse und insbesondere hochfrequenzdichtes Filtergehäuse geschaffen, welches zudem Intermodulationsprobleme extrem stark vermindert oder sogar völlig vermeidet.

Im Rahmen der Erfindung sind dabei an dem oben umlaufenden Rand des Gehäuses, der üblicherweise mit der Deckelunterseite eines aufzusetzenden Deckels in Kontakt tritt, erste Gehäuse-Randabschnitte vorgesehen oder gebildet, die jeweils zu zweiten Gehäuse-Randabschnitten angeordnet oder gebildet sind. Alternativ oder ergänzend sind an der Gehäusedeckel-Unterseite erste und dazu in Umfangsrichtung versetzt liegende zweite Gehäusedeckel-Randabschnitte vorgesehen oder gebildet. Ebenso sind an der Gehäusedeckel-Unterseite erste und dazu in Umfangsrichtung versetzt liegende zweite Gehäusedeckel-Randabschnitte ausgebildet. In montierter Position liegt der Gehäusedeckel auf dem Gehäuse auf, wobei die ersten Gehäuse-Randabschnitte des Gehäuses mit den ersten Gehäusedeckel-Randabschnitten des Gehäusedeckels in elektrisch-galvanischen Kontakt treten, wohingegen die zweiten Gehäuse-Randabschnitte und/oder Gehäusedeckel-Randabschnitte so gebildet sind, dass hier eine galvanische Trennung zwischen Gehäuse und Gehäusedeckel bewirkt wird, hier also eine elektrisch kontaktfreie benachbarte Positionierung der Gehäuse-Randabschnitte und der Gehäusedeckel-Randabschnitte vorliegt.

Die Schraubverbindungen sind in denjenigen Bereichen vorgesehen, in denen die Gehäuse-Randabschnitte des Gehäuserandes und/oder des Gehäusedeckels sich mechanisch berühren und in diesem Auflagen- und Berührungsbereich elektrisch-galvanisch miteinander kontaktiert sind. Dadurch ist sichergestellt, dass ausschließlich in diesem Kontaktbereich der Gehäusedeckel mit dem Gehäuse durch Festdrehen der erwähnten Schrauben fest verbunden ist. Mittels der durch die Schrauben erzeugten hohen Kontaktkräfte wird ein eindeutig reproduzierbarer elektrisch-galvanischer Kontakt zwischen Gehäusedeckel und Gehäuse erzeugt, wodurch Intermodulationen vermieden oder deutlich verringert werden können.

In denen Bereichen, wo die Schraubverbindungen nicht vorgesehen sind, kommen dann die jeweiligen Abschnitte des Gehäusedeckels und des Gehäuserandes benachbart zueinander unter Ausbildung eines galvanischen Trennbereiches kontaktfrei so zu liegen, dass hier eine galvanische Kontaktierung vermieden ist.

Dadurch lässt sich das erwähnte hochfrequenzdichte Filtergehäuse realisieren, allerdings unter Vermeidung bzw. maximaler Unterdrückung von unerwünschten Intermodulationen.

Die Erfindung schlägt also vor, dass beispielsweise am Gehäuserand versetzt zueinander liegende elektrisch leitfähige Kontaktabschnitte ausgebildet sind, auf denen dann der ebenfalls elektrisch leitfähige Gehäusedeckel ruht, so dass nur im Bereich der elektrisch leitfähigen Kontaktabschnitte ein elektrisch-galvanischer Kontakt gegeben ist. Zwischen den elektrisch leitfähigen Kontaktabschnitten sollen dann beispielsweise am Gehäuserand oder an der Gehäusedeckel-Unterseite elektrisch nicht leitfähige, d.h. galvanisch-kontaktfreie Trennbereiche ausgebildet sein.

Umgekehrt können auch an dem Deckel versetzt zueinander liegende Kontaktabschnitte ausgebildet sein, mit denen der Gehäusedeckel dann auf dem elektrisch leitfähigen Gehäuserand aufliegt und hier galvanische Kontaktstellen bildet, zwischen denen wiederum galvanisch-kontaktfreie Trennbereiche gebildet sind.

Ebenso können am Gehäuserand einerseits wie an dem Deckel andererseits versetzt zueinander liegende elektrisch leitfähige Kontaktabschnitte ausgebildet sein, zwischen denen bevorzugt jeweils elektrische Trennstellen vorgesehen oder spätestens beim Aufsetzen des Deckels auf dem Gehäuse gebildet sind. Kommen dabei die elektrisch leitfähigen Kontaktabschnitte, die zum einen an dem Gehäusedeckel und zum anderen an dem Gehäuserand ausgebildet sind, ganz oder teilweise überlappend durch Aufsetzen des Deckels auf dem Gehäuse in Kontakt, werden in diesem überlappenden Kontaktbereich die galvanischen Kontaktbereiche gebildet, zwischen denen elektrisch-galvanische Trennbereiche, also kontaktfreie Bereiche erzeugt werden.

In all diesen Fällen sind die Schraubverbindungen nur in denen Bereichen vorgesehen, in denen die elektrischgalvanischen Kontaktbereiche ausgebildet sind, so dass hier durch die hohen Anpresskräfte die eindeutig reproduzierbaren elektrischen Kontaktbedingen erzeugt werden, die die unerwünschten Intermodulationen vermeiden oder deutlich verringern.

In einer bevorzugten Ausführungsform ist dazu vorgesehen, dass der dem Deckel zugewandt liegende umlaufende Rand des (boxenförmigen) Gehäuses und der darauf aufsetzende Rand des Deckels definierte Auflageflächen im Bereich der Schrauben aufweist, und dass im Zwischenbereich zwischen zwei aufeinander folgenden Schrauben zwischen den aufeinander zu liegenden Flächen des umlaufenden Randes des Gehäuses und des Deckels ein Spalt gebildet ist. Mit anderen Worten wird hier zwischen den Schrauben eine undefinierte Deckelauflage durch die Ausbildung eines gegebenenfalls höchst gering dimensionierten Spaltes verhindert.

Wie ausgeführt, befinden sich im Rahmen der Erfindung die Schraubverbindungen in einem Befestigungsbereich, der durch erhabene Gehäuse-Randabschnitte und/oder erhabene Gehäusedeckel-Randabschnitte gekennzeichnet ist. Diese erhabenen Abschnitte müssen aber um die entsprechende Bohrung zur Durchführung der Schraube nicht voll geschlossen sein. Möglich ist auch, dass diese erhabenen Abschnitte beispielsweise scheibenförmig gestaltet sind. Möglich ist auch, dass die erhabenen Abschnitte beispielsweise in Form von zwei parallel zueinander verlaufenden Stegen bestehen, zwischen denen die Bohrung zum Eindrehen der Befestigungsschraube vorgesehen ist. Diese Stege können nicht nur parallel zur entsprechenden Gehäusewand, sondern bevorzugt quer oder senkrecht dazu ausgerichtet verlaufen. Sie müssen sich nicht einmal über die gesamte Wandbreite erstrecken. Ausreichend ist eine kürzere Dimensionierung benachbart zu dem dazwischenliegenden Bohrloch.

Ferner hat es sich als besonders günstig erwiesen, wenn die erhabenen Abschnitte nicht eckig oder kantig zur Auflagefläche auslaufen, sondern mit Rundungen versehen sind, beispielsweise wulstförmigen Rundungen etc..

Die erfindungsgemäße Lösung gewährleistet also, dass die Kontaktstellen an den Schraubbefestigungen eindeutig definiert sind und dabei mit sehr hohem Kontaktdruck belastet sein können, weil nur hier die Kontaktkräfte zwischen Deckel und aufliegenden Kontakt- und Druckflächen des umlaufenden Randes des Gehäuses wirken können. Durch die Ausbildung von Trennabschnitten, zum Beispiel in Form von gegebenenfalls geringst dimensionierten Spalten oder Abständen in Bereichen zwischen zwei benachbarten Schraubbefestigungen wird hier eine Deckelauflage vermieden. Durch die entsprechende Abstandsfolge der Schrauben ist eine derartige Ausgestaltung gleichwohl hochfrequenzdicht. Dabei ist also die Gestaltung des Filtergehäuses höchst einfach, da an kritischen Stellen einschließlich der Ecken eine plane Deckelauflage nicht mehr erforderlich ist. Im Rahmen der Erfindung lassen sich dabei die Filtereigenschaften wie Dämpfung, VSWR etc. gleichwertig, d.h. vor allem eindeutig reproduzierbar erreichen. Das ist insofern erstaunlich, da man bei so resonanten Strukturen wie einem Filter davon ausgehen würde, dass jede Öffnung eine massive Auswirkung auf die benannten elektrischen Eigenschaften haben würde.

In abgewandelten Ausführungsformen der Erfindung werden die erfindungsgemäßen Vorteile dadurch realisiert, dass durch geeignete Maßnahmen nur an den gewünschten Abschnitten eine elektrisch-galvanische Kontaktierung zwischen Gehäusedeckel und Gehäuse (nämlich im Bereich dieser Abschnitte durchsetzenden Schraubbefestigung) erzeugt wird, wohingegen in den Abschnitten zwischen den Schraubverbindungen eine elektrische Kontaktierung zwischen Deckel und Gehäuse vermieden wird.

Dies kann beispielsweise dadurch erreicht werden, dass ein Gehäusedeckel verwendet wird, der aus einem Dielektrikum insbesondere in Form einer Leiterplatte gebildet ist. Die Leiterplatte ist mit einer metallisierenden Schicht versehen. Auf der Unterseite des Gehäusedeckels ist jeweils in einem Bereich zwischen zwei Schraubverbindungen eine metallisierende Schicht weggelassen oder entfernt, so dass das darunter befindliche Dielektrikum zum Gehäuse hin offenliegt. Dabei ist bevorzugt der Bereich der fehlenden oder entfernten Galvanisierung auf der Gehäusedeckel-Unterseite in einem breiteren Abschnitt weggelassen, breiter als der Auflageabschnitt der darunter befindlichen Gehäusewand des Gehäuses, so dass in diesem Bereich keine elektrische Kontaktierung zwischen Gehäusedeckel und den entsprechenden Flächenabschnitten der Gehäusewand vorliegen kann.

Ebenso ist es aber auch möglich, dass beispielsweise das Gehäuse, üblicherweise boxenförmige oder boxenähnliche Gehäuse, zum Beispiel aus einem Dielektrikum (beispielsweise aus einem Kunststoff wie Platinenmaterial) besteht und an seiner innenliegenden und außenliegenden Oberfläche einschließlich der oberen, üblicherweise mit der Deckelunterseite in Kontakt tretenden Fläche mit einer elektrisch leitfähigen Schicht überzogen ist, und dass dann an dem üblicherweise mit der Deckelunterseite in elektrischen Kontakt tretenden Gehäuserand die Metallisierung der entsprechenden Flächenabschnitte nicht ausgebildet und/oder entfernt sind, so dass hier eine galvanische Trennungsstelle zwischen zwei aufeinanderfolgenden Schraubverbindungen ausgebildet ist. Bevorzugt ist in dieser Variante auch an dem angrenzenden Oberflächenbereich an der Innen- und Außenseite einer entsprechenden Gehäusewand die Metallisierung zumindest in einem geringen Höhenmaß weggelassen, damit auch hier nicht unbeabsichtigt ein galvanischer Kontakt zwischen den metallisierten Innen- und/oder Außenflächen des Gehäuses mit der galvanisierten Innenfläche des Deckels verursacht werden kann.

Natürlich können an den entsprechenden Stellen sowohl an der Deckelunterseite wie an dem umlaufenden Gehäuserand jeweils gemeinsam entsprechende Abschnitte ohne entsprechende metallisierte Schicht ausgebildet sein.

Grundsätzlich könnten umgekehrt auch an den gewünschten Stellen zwischen zwei Schraubverbindungen bevorzugt sehr dünne, isolierende Schichten auf der Deckelunterseite oder an dem Gehäuse und insbesondere am umlaufenden Gehäuserand ausgebildet sein, um ansonsten die vorhandene galvanische Kontaktierung zwischen Deckel und Gehäuse zu vermeiden und zu unterbinden.

Allgemein lässt sich die Erfindung zusammen wie folgt charakterisieren:
- zwischen dem Gehäusedeckel und dem Gehäuse sind mehrere versetzt zueinander angeordnete Kontaktabschnitte gebildet oder vorgesehen,
- zwischen den Kontaktabschnitten sind galvanische Trennabschnitte gebildet oder vorgesehen, in deren Bereichen der Gehäusedeckel und das Gehäuse galvanisch getrennt sind, und
- die Schraubverbindungen sind in den Kontaktabschnitten vorgesehen, in deren Bereichen der Gehäusedeckel mit dem Gehäuse galvanisch kontaktiert ist.

Die Erfindung wird nachfolgend anhand von Zeichnungen näher erläutert. Dabei zeigen im Einzelnen:
- Figur 1:: eine schematische räumliche Darstellung eines offenen Gehäuses eines HF-dichten Gesamtgehäuses ohne Deckel;
- Figur 2:: eine Draufsicht auf das in Figur 1 in Seitenansicht dargestellte offene Gehäuse;
- Figur 2a:: eine zu Figur 2 leicht abgewandelte Darstellung unter Verdeutlichung, dass die einzelnen Kammern der Resonatoren auch durch Ausbildung von Blenden unter Verwendung von Begrenzungswänden gegliedert sein können;
- Figur 3:: eine räumliche Darstellung eines Gehäusedeckels zur Abdichtung des in Figur 1 gezeigten offenen Teiles des Gesamtgehäuses;
- Figur 4:: eine schematische Seitenansicht des in Figur 1 gezeigten offenen Gehäuses;
- Figur 5:: eine schematische Detaildarstellung in Seitenansicht bezüglich des in Figur 3 gezeigten Teiles A;
- Figur 6:: eine vergrößerte Seitendarstellung eines abgewandelten Deckels in auszugsweiser Seitendarstellung;
- Figur 7:: ein nochmals leicht abgewandeltes Ausführungsbeispiel in ausschnittsweiser Seitendarstellung vergleichbar zu Figur 5;
- Figur 8:: ein zu Figur 5 leicht abgewandeltes Ausführungsbeispiel mit abgerundeten Kanten;
- Figur 9:: ein nochmals zu Figur 5 und zu Figur 8 leicht abgewandeltes Ausführungsbeispiel mit doppelseitig abgerundeten Kanten;
- Figur 10:: ein zu Figur 2 in Draufsicht gezeigtes abgewandeltes Ausführungsbeispiel, bei welchem die Wände des Gehäuses im Bereich der Bohrung eine größere Dicke aufweisen, als dazwischenliegende Abschnitte;
- Figur 11:: eine Vertikalschnittdarstellung in Längsrichtung durch eine Gehäusewand unter Darstellung dreier Abwandlungen unter Ausbildung von erhabenen Gehäuse-Randabschnitten;
- Figur 12:: eine entsprechende Draufsicht auf die Ausführungsbeispiele nach Figur 11;
- Figur 13:: ein nochmals geringfügig abgewandeltes Ausführungsbeispiel mit einem umlaufenden Rand versehenen Deckel;
- Figur 14:: eine ausschnittsweise Unteransicht des Gehäusedeckels bezüglich einer abgewandelten Ausführungsform der Erfindung; und
- Figur 15:: eine auszugsweise perspektivische Ansicht eines Abschnitts der Gehäusewand bezüglich einer nochmals abgewandelten Ausführungsform der Erfindung.

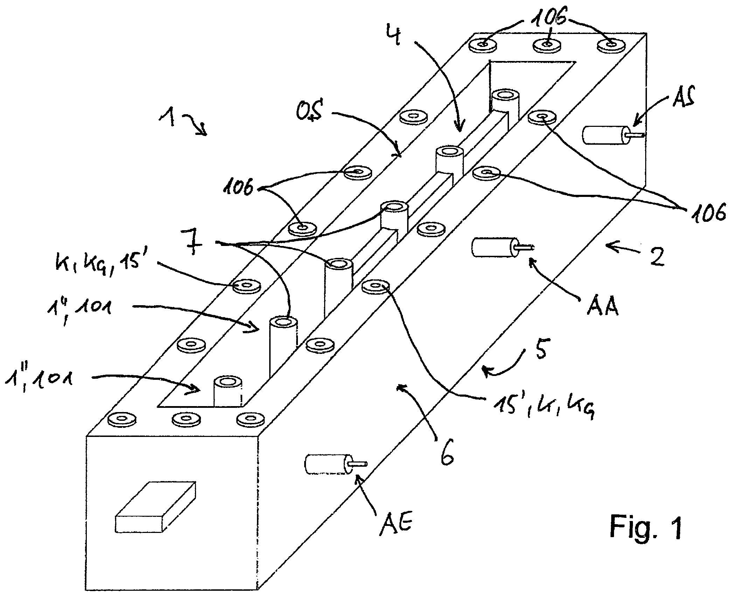

Anhand der Figuren 1 bis 5 ist ein erstes Ausführungsbeispiel eines erfindungsgemäßen hochfrequenzdichten Gehäuses unter Vermeidung von Intermodulationsproblemen gezeigt, insbesondere in Form eines Filters bestehend aus koaxialen Resonatoren. Diese Filter werden auch koaxiale Hohlraumfilter genannt, welche grundsätzlich als Bandpassfilter, als Bandsperrfilter etc. ausgebildet sein können. Im vorliegenden Fall kann das Filter beispielsweise als Duplexweiche eingesetzt werden, wie sie im Rahmen der Mobilfunktechnik benötigt werden.

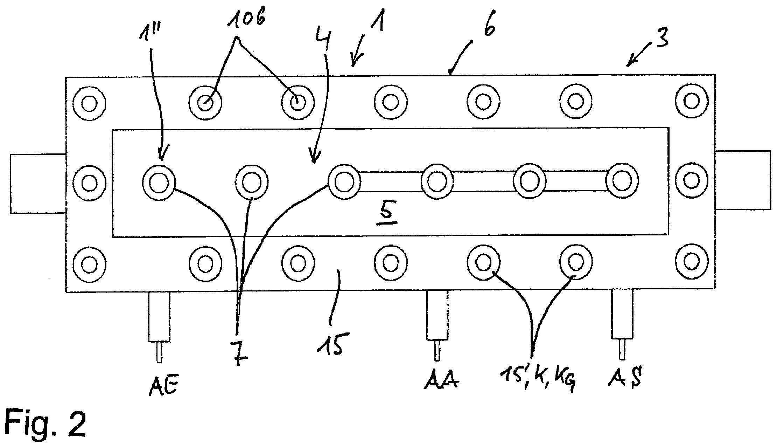

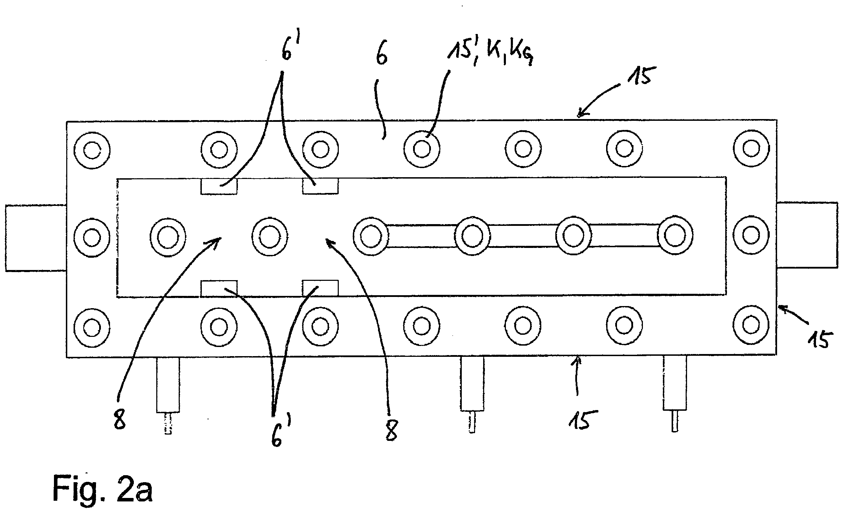

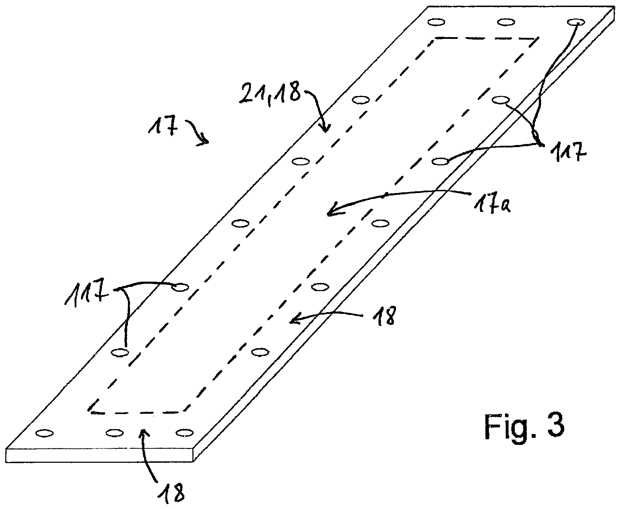

Gemäß dem gezeigten Ausführungsbeispiel umfasst das koaxiale Hohlraumfilter 1, welches nachfolgend teilweise auch lediglich als Hohlraumfilter oder Koax-Filter 1 bezeichnet wird, ein kastenförmiges Gesamtgehäuse 2, welches zumindest an einer Seite hin (hier nach oben hin) offen ist. Diese offene Seite OS wird für den Betrieb des Koax-Filters durch einen Deckel 17 (siehe Figur 3) verschlossen. Das Gehäuse 2 weist des Weiteren einen Boden 5, eine umlaufende Gehäusewand 6 und in dem so gebildeten Innenraum 4 vorgesehene Innenleiter 7 auf, die sich vom Boden 5 über eine Teilhöhe des Gehäuses 3 senkrecht erstrecken.
Das in Figur 1 und Figur 2 (dort bei weggelassenem Deckel) gezeigte Hohlraumfilter ist in der Regel in Kammern 101 gegliedert, die durch Begrenzungswände definiert werden, wobei die Begrenzungswände jeweils aus beispielsweise zwei von der Gehäusewand 6 nach innen vorstehenden Wandabschnitten 6' gebildet sein können, wie dies in Figur 2a dargestellt ist. Ebenso kann es in vielen Fällen ausreichend sein, wenn nur von einer Gehäuse-Innenwand ein entsprechender Wandabschnitt 6' vorsteht. In beiden Fällen werden quasi Blenden oder Fenster 8 zwischen den nur teilweise nach innen vorstehenden Wandabschnitten 6' oder dem nur einen nach innen vorstehenden Wandabschnitt an der gegenüberliegenden GehäuseInnenseite gebildet, wobei über diese Blenden oder Fenster 8 die einzelnen koaxialen Resonatoren 1" miteinander verkoppelt sein können.

Im Bereich von vorgesehenen Anschlüssen sind in dem jeweiligen Koax-Filter 1" geeignete Maßnahmen zum Ein- und Auskoppeln der Signale vorgesehen, wobei insoweit auf bekannte Lösungen verwiesen wird. An den vorgesehenen Eingangs- bzw. Ausgangsanschlüssen AE, AA, AS können ansonsten übliche Koaxialstecker mit entsprechenden Leitungsverbindungen angeschlossen werden.

Das so aufgebaute kastenförmige Gehäuse 3 mit dem Gehäuseboden 5 und dem Innenleiter 7 kann aus einem metallischen Fräs- oder Gussteil gebildet sein. Bevorzugt wird hierfür Aluminium verwendet.

Grundsätzlich wird angemerkt, dass die Erfindung auch unter Verwendung eines Gehäuses 3 und/oder eines Gehäusedeckels 17 (Figur 3) realisiert werden kann, welches aus einem dielektrischen Material (insbesondere Kunststoff) besteht. In diesem Fall müsste das Gehäuse 3, also die Gehäusewand 6, der Gehäuseboden 5, die Innenleiter 7 und der Gehäusedeckel 17 mit einer elektrisch leitfähigen Schicht, in der Regel einer Metallschicht, überzogen sein. Dabei müssen vor allem die Innenwandungen und Innenflächen des Gehäuses 3 mit der elektrisch leitfähigen Schicht überzogen sein (die also dem Innenraum zugewandt liegt), einschließlich des umlaufenden Gehäuserandes 15. Auf Seiten des Gehäusedeckels 17 muss die dem Innenraum zugewandt liegende Gehäusedeckel-Unterseite 17a mit einer elektrisch leitfähigen Schicht überzogen sein, so dass in dem Randbereich 18 nicht nur eine mechanische, sondern auch eine galvanische Kontaktierung möglich ist.

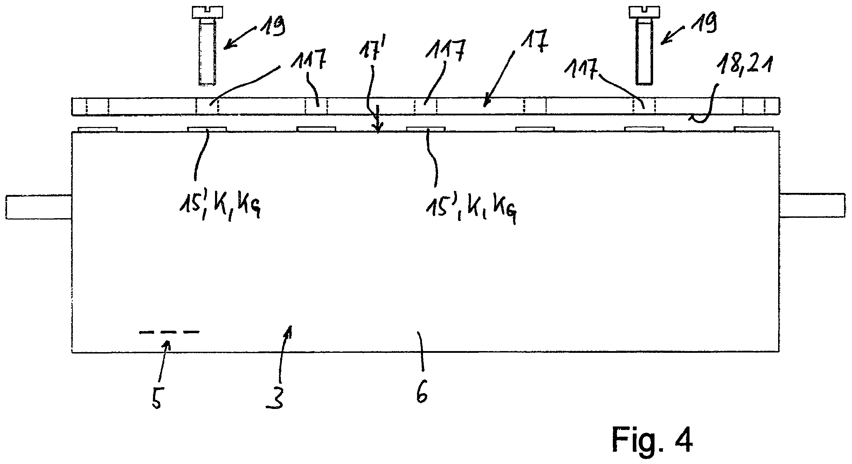

Auf dem umlaufenden, vom Boden 5 wegweisenden Gehäuserand 15 des Gehäuses 3 wird ein Gehäusedeckel 17 aufgelegt und mittels einer Vielzahl von Schraubverbindungen 25, hier in Form von Schrauben 19, mit dem Gehäuse 3 fest verschraubt. In Figur 4 ist dabei das Gehäuse 17 oder Teilgehäuse 3, der erwähnte Gehäusedeckel 17 und einige der Befestigungsschrauben 19 im Sinne einer Explosionszeichnung übereinander angeordnet. Mittels Pfeildarstellung 17' ist dabei ferner gezeigt, dass der Gehäusedeckel 17 auf dem umlaufenden Rand 15 des (offenen) Gehäuses 3 aufgelegt und dann der Gehäusedeckel 17 befestigt wird. Dazu werden die Befestigungsschrauben 19 durch eine entsprechende Anzahl von Befestigungsbohrungen 117 hindurchgesteckt (die im Gehäusedeckelrand 18 ausgebildet sind) und fluchtend in die vorgesehenen Gewindebohrungen 106 der Gehäusewand 15 eingedreht, worauf später noch genauer eingegangen wird.

Um die einzelnen koaxialen Resonatoren 1", d.h. den Innenraum 4 der Hochfrequenzhohlraumfilter 1 HF-mäßig dicht nach außen hin abzuschirmen und Intermodulationsprobleme zu vermeiden, ist in einem ersten Ausführungsbeispiel anhand der erläuterten Figuren 1 bis 5 vorgesehen, dass der Gehäusedeckel 17 beispielsweise eben oder plan ist oder zumindest einen ebenen oder planen umlaufenden Rand 18, 21 oder eine entsprechende umlaufende Randfläche 18, 21 aufweist.

In Figur 3 ist dabei der Gehäusedeckel 17 in räumlicher Darstellung gezeigt, und zwar von seiner Unterseite 17a her. Mit anderen Worten wird auf das nach oben hin offene kastenförmige Gehäuse 3 der Gehäusedeckel 17 mit seinem umlaufenden Gehäusedeckelrand 18 aufgelegt. Dieser umlaufende Rand 18, d.h. diese umlaufende Randfläche 18 ist dabei strichliert angedeutet.

Dieser Gehäusedeckel 17 liegt mit seinem Gehäusedeckelrand 18 bzw. dieser Randfläche 18 (wie nachfolgend erörtert wird nur partiell) auf dem umlaufenden Gehäuserand 15 auf.

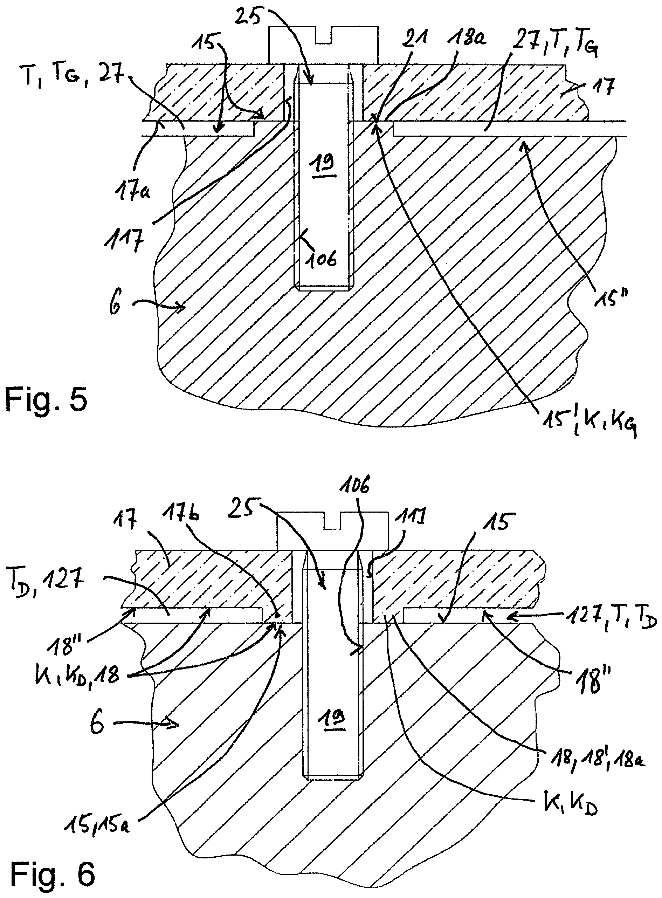

Wie allerdings durch die Seitenansicht gemäß Figur 4 als auch aus der vergrößerten Detaildarstellung gemäß Figur 5 (welche eine Vergrößerung eines Bereiches in Figur 4 im Vertikalschnitt wiedergibt) zu ersehen ist, weist der Gehäuserand 15 kein gleichbleibend hohes Niveau auf, ist also insgesamt nicht eben oder plan gestaltet. Figur 5 zeigt dabei, dass der umlaufende Gehäuserand 15 in einzelne Gehäuse-Randabschnitte gegliedert ist, nämlich sogenannte erhabene, also in Richtung Gehäusedeckel 17 vorstehende Gehäuse-Randabschnitte 15', auf die vertieft liegende, also zurückversetzte Gehäuse-Randabschnitte 15" folgen. Figur 5 zeigt dabei in Seitendarstellung (teilweise im Schnitt angedeutet), dass der Gehäusedeckel 17 als Platte ausgebildet ist, so dass der erwähnte plane Gehäusedeckelrand 18 nur an den erhabenen GehäuseRandabschnitten 15' aufliegen kann. In diesem Bereich, wo also der Gehäusedeckel 17 mit seinen entsprechenden Abschnitten der Randfläche 21 auf den erhabenen Gehäuse-Randabschnitten 15' des Gehäuserandes 15 aufliegt, wird ein galvanischer Kontakt zwischen der Unterseite 17a des Gehäusedeckels 17 und den erhabenen Gehäuse-Randabschnitten 15' der Gehäusewand 6 bewirkt. Lediglich in diesen Bereichen 18a erzeugen die eingedrehten Schrauben 19 einen entsprechenden Anpressdruck, mit dem der Deckel 17 am kastenförmigen Gehäuse 3 angepresst gehalten wird. In diesem Ausführungsbeispiel werden also durch die erhabenen Gehäuse-Randabschnitte 15' am Gehäuse gehäuseseitige Kontaktabschnitte oder Kontaktbereiche K_{G} gebildet, die bei aufgesetztem Deckel mit der Deckelunterseite in Kontakt treten. Der Randabschnitt auf der Deckelunterseite, der mit den erhabenen Gehäuse-Randabschnitten 15' in Berührung und damit in galvanischen Kontakt tritt, bildet somit deckelseitige Kontaktbereiche oder Kontaktabschnitte K_{D}, wobei in diesem Ausführungsbeispiel die deckelseitigen Kontaktbereiche oder Kontaktabschnitte ohne Vorsprünge und ohne vertiefte Abschnitte eben ausgebildet sind. Da das Gehäuse und der Gehäusedeckel aus einem elektrisch leitfähigen Material bestehen und/oder (wenn sie beispielsweise aus Kunststoff oder einem anderen Dielektrikum bestehen) mit einer elektrisch leitfähigen Schicht überzogen sind, werden durch die erläuterten in Montagerichtung (also in Richtung des Gehäusedeckels) vorstehenden und erhabenen Gehäuse-Randabschnitte 15' elektrisch-galvanische Auflage- und/oder Kontaktabschnitte K gebildet, auf denen der Gehäusedeckel aufliegt. Die Kontaktabschnitte K werden hier also durch Gehäuse-Kontaktabschnitte K_{G} gebildet, um die erwünschte galvanische Kontaktierung in diesem Bereich zu bewirken.

Die am Gehäuse ausgebildeten und gegenüber dem Gehäusedeckel 17 zurückversetzten oder vertieften Gehäuse-Randabschnitte 15" bilden demgegenüber galvanische Trennstellen, also kontaktfreie Trennbereiche oder Trennabschnitte T, nämlich im Konkreten bezüglich des Gehäuses oder Gehäuserandes kontaktfreie Trennbereiche oder Trennabschnitte T_{G}. Die im zusammenmontierten Zustand direkt dazu benachbart oder oberhalb der zurückversetzten Gehäuse-Randabschnitte 15" zu liegen kommenden Randabschnitte auf der Deckelunterseite, die somit im Abstand zum Gehäuserand zu liegen kommen, bilden somit ebenfalls die erwähnten Trennbereiche oder Trennabschnitte T, das heißt im Konkreten Trennbereiche oder Trennabschnitte T_{G}, die am Deckel in diesen Bereichen vorhanden sind, selbst wenn diese Abschnitte elektrisch leitfähig sein sollen. Denn zwischen zwei derartig erhabenen Gehäuse-Randabschnitten 15' befinden sich dann gegenüber dem Gehäusedeckel 17 etwas beabstandeten, also vertieft ausgebildeten Gehäuse-Randabschnitte 15", so dass hier zwischen diesem vertieften Gehäuse-Randabschnitt 15" und der Unterseite 17a des Gehäusedeckels 17 ein Spalt 27 ausgebildet ist. In diesem Bereich kann also keine galvanische und mechanische Kontaktwirkung eintreten.

Durch die entsprechend dichte Folge von benachbart sitzenden Schraubverbindungen 25 mit den Schrauben 19 entsprechend der Abstandsfolge der Bohrungen 106 ist gleichwohl sichergestellt, dass das Gesamtgehäuse 2 mit dem aufgesetzten Gehäusedeckel 17 hochfrequenzdicht ist. Mit anderen Worten sind die in ihrer Höhe gegebenenfalls nur höchst gering dimensionierten Spalte 27 unschädlich für die Herstellung einer hochfrequenzdichten Schirmung.

Wichtig ist vor allem, dass die anhand von Figur 5 angedeuteten Schrauben 19 durch die Befestigungsbohrungen 117 im Gehäusedeckel 17 so in die Gewindebohrungen 106 in den Seitenwänden 6 eingedreht werden können, dass der Gehäusedeckel 17 an den mit den erhabenen Gehäuse-Randabschnitten 15' in Kontakt stehenden Gehäusedeckel-Randabschnitten 18a mit überdurchschnittlich hohen Kontaktdrücken angepresst werden kann. Mit anderen Worten wird in diesen Randabschnitten 18a (die auf den entsprechend erhabenen Gehäuse-Randabschnitten 15' des Gehäuses 3 aufliegen) eine hohe Kraftdrücke aufweisende feste und eindeutig reproduzierbare galvanische Verbindung sichergestellt, und zwar durch die definierten Kontaktflächen, die von den Schraubverbindungen 25 durchsetzt werden. Diese definierten Kontaktflächen werden letztlich durch die zwischen den Kontaktflächen vorgesehen Spalte 27 gebildet.

Anhand von Figur 6 ist eine Umkehrung des bisher beschriebenen Lösungsprinzips gezeigt, bei welchem der Gehäusedeckel 17 beispielsweise eine in geringer Höhe vorzugsweise umlaufende Gehäusedeckelwand 17b aufweisen kann. Auch in diesem Ausführungsbeispiel gliedert sich der an der Gehäusedeckelwand 17b ausgebildete umlaufende Gehäusedeckel-Rand 18 der Gehäusedeckelwand 17b in unterschiedliche Abschnitte, nämlich in erhabene (d.h. in Richtung offene Gehäusebox 3) vorstehende Gehäusedeckel-Randabschnitte 18' und in demgegenüber von der benachbarten Gehäusewand 6 etwas entfernter liegende, vertiefte Gehäusedeckel-Randabschnitte 18".

Hierdurch wird eine völlig vergleichbare Lösung geschaffen, bei der ein entsprechend auf den Gehäuserand 15 aufgesetzter Gehäusedeckel 17 nur mit seinen erhabenen vorstehenden Gehäusedeckel-Randabschnitten 18' auf dem umlaufenden Gehäuserand 15 des Gehäuses 3 in Bereichen 15a aufliegen kann (also nur an den sogenannten Gehäuse-Randabschnitten 15a, die mit den erhabenen, vorstehenden Auflageflächen der Gehäusedeckel-Randabschnitte 18' in Kontakt treten). Zwischen den erhabenen Gehäusedeckel-Randabschnitten 18' liegen dann die demgegenüber vertieften oder zurückgesetzten Gehäusedeckel-Randabschnitte 18", zwischen denen und dem umlaufenden Gehäuserand 15 dann die erwähnten Spalte 127 ausgebildet sind.

Durch diese Spalte 127 sind die vertieften Gehäusedeckel-Randabschnitte 18" von der Gehäusewand 6 des Gehäuses 3 beabstandet.

Auch bei dieser Ausführungsform sind die Bohrungen 117 im Gehäusedeckel 17 und die dazu fluchtenden Bohrungen 106 in der Gehäusewand 6 an den Stellen ausgebildet, an denen der Gehäusedeckel 17 mit seinen erhabenen Gehäusedeckel-Randabschnitten 18' auf der Gehäusewand 6 des Gehäuses 3 aufliegt. Auch dadurch wird in diesem Bereich durch die hohen Anpressdrücke der Schrauben 19 eine gute mechanische Verbindung und zudem eine gute elektrisch-galvanische Verbindung geschaffen, weil durch die Ausbildung der erwähnten Spalte 127 im Bereich der Schraubverbindungen 25 definierte Kontaktflächen geschaffen werden.

Auch bei dem Ausführungsbeispiel nach Figur 6 werden also an der Deckelunterseite galvanische Kontaktabschnitte K gebildet, die auch als Gehäusedeckel-Kontaktabschnitte K_{D} bezeichnet werden. Wird ein entsprechender Gehäusedeckel 17 auf den umlaufenden Rand des Gehäuses aufgelegt, treten diese vorstehenden Gehäusedeckel-Kontaktabschnitte K_{D} mit dem umlaufenden Rand des Gehäuses in mechanischen Kontakt und bewirken in dem Kontakt- und Auflagebereich eine elektrisch-galvanische Kontaktierung. Im Eigentlichen Kontakt- und Auflagebereich der Gehäusedeckel-Kontaktabschnitte K_{D} werden die Gehäuse-Kontaktabschnitte K_{G} gebildet. In diesen aufeinanderliegenden Bereichen sind die entsprechenden Bohrungen 106 zur Aufnahme der Schraubverbindungen vorgesehen, um hier den Deckel mechanisch fest am umlaufenden Rand des Gehäuses durch Festdrehen der Schrauben fixieren zu können. Versetzt zu den erwähnten Kontaktabschnitten K sind dann bei dem Ausführungsbeispiel gemäß Figur 6 die zurückversetzten oder zur Deckeloberseite tiefer liegenden Trennstellen T vorgesehen, die hier auch als Gehäusedeckel-Trennstellen T_{D} bezeichnet werden. Diese Gehäusedeckel-Trennstellen T_{D} liegen also unmittelbar benachbart galvanisch getrennt und damit kontaktfrei zu den entsprechenden Abschnitten auf dem Gehäuserand des Gehäuses, wobei diese kontaktfreien Abschnitte dann auch als Gehäuse-Trennbereiche oder Gehäuse-Trennabschnitte T_{G} bezeichnet werden.

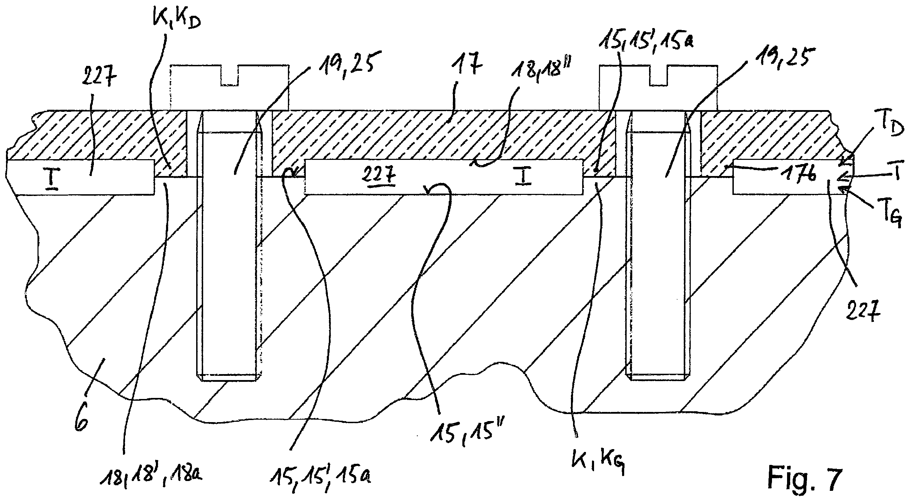

Anhand von Figur 7 ist nur in Abweichung zu den vorstehend genannten Ausführungsbeispielen gezeigt, dass das Prinzip anhand von Figur 5 sowie das weitere Prinzip, wie es anhand von Figur 6 erläutert wurde, auch kombiniert werden kann. In diesem Fall weist also der umlaufende Gehäuserand 15 eine Reihe von Abstufungen auf, d.h. die in Richtung Gehäusedeckel 17 etwas weiter vorstehenden Auflage- und/oder Kontaktflächen, die als erhabene Gehäuse-Randabschnitte 15' definiert wurden. Daneben ist auch der Gehäusedeckel 17 mit den erhabenen Gehäusedeckel-Randabschnitten 18' ausgestattet, wie dies anhand von Figur 6 gezeigt wurde. Somit liegen die jeweils erhabenen Gehäusedeckel-Randabschnitte 18' auf den erhabenen Gehäuse-Randabschnitten 15' vollflächig oder nur teilweise überlappend auf. Die jeweils dazu versetzt liegenden vertieften, d.h. zurückgesetzten Gehäusedeckel-Randabschnitte 18" sowie die ebenso vertieften, also zurückversetzten Gehäuse-Randabschnitte 15" bilden dann jeweils einen dazwischen liegenden Spalt 227. Die Schrauben 19 durchsetzen dabei wiederum die Befestigungsbohrungen 117 im Gehäusedeckel 17 und sind in ein Innengewinde in die Gewindebohrung 106 im Gehäuse 3 eingedreht. Dabei durchsetzen die Bohrungen 117 den Gehäusedeckel 17 in den erhabenen Gehäusedeckel-Randabschnitten 18' und die Bohrungen 19 sind in der Gehäusewand 6 im Bereich der erhabenen Gehäuse-Randabschnitte 15' eingebracht. Dabei sind die Anordnungen und die Größe der in Kontakt tretenden Flächen an den erhabenen Gehäuse-Randabschnitten 15' und den Gehäusedeckel-Randabschnitten 18' bevorzugt gleich ausgebildet, bevorzugt also mit gleicher Flächengröße und an gleicher Stelle, d.h. in der gleichen Position vorgesehen, so dass deren zugehörigen Flächen möglichst vollflächig aufeinander liegen. Besonders vorteilhaft hinsichtlich der Intermodulationstauglichkeit erweist es sich, dass die Kanten der erhabenen Gehäusedeckel-Randabschnitte 18' sowie der erhabenen Gehäuse-Randabschnitte 15' abgerundet bzw. mit einem Radius versehen werden.

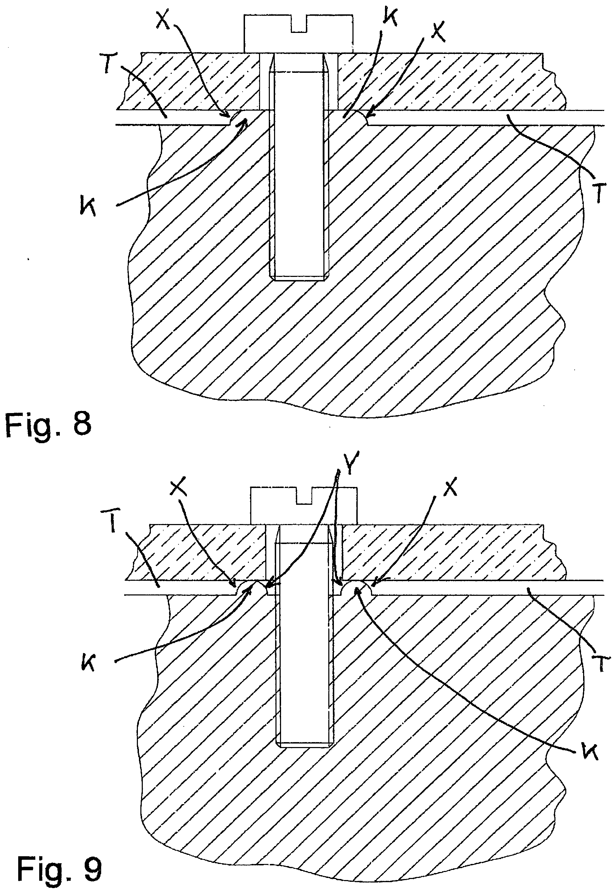

In Figur 8 ist von daher eine zu Figur 5 abweichende Darstellung wiedergegeben, bei der die erhabenen Gehäuse-Randabschnitte 15' zur jeweiligen Schraube 19 entfernt liegen, benachbart zur Unterseite 17a des Deckels 17 mit einer im Schnitt abgerundeten Kante X versehen sind. Der Radius kann dabei bevorzugt in der Größenordnung der Höhe des Schlitzes 27 liegen.

Bei der Variante gemäß Figur 9 weisen die erhabenen Gehäuserandabschnitte 15' sogar abgerundete Kanten nicht nur auf der zur jeweiligen Schraube 19 entfernt liegenden Seite, sondern auch auf der der Schraube 19 zugewandt liegenden Seite auf, also eine abgerundete Kante X sowie gegenüberliegend eine abgerundete Kante Y. Mit anderen Worten sollte der Radius dieser Abrundungen X und/oder Y zumindest 10% der Höhe des Abstandsspaltes 27 (oder 127) bei dem Ausführungsbeispiel gemäß Figur 6 oder 227 bei dem Ausführungsbeispiel gemäß Figur 7 betragen, insbesondere mehr als 20%, 30%, 40%, 50%, 60%, 70%, 80%, 90% oder 100% der Höhe des in Rede stehenden Abstandes. Üblicherweise ist der Radius kleiner oder gleich der Höhe des Abstandes, insbesondere kleiner als 90%, 80%, 70%, 60%, 50%, 40%, 30% oder 20% der Höhe des Abstandsspaltes.

Dabei wird ferner angemerkt, dass die entsprechenden Abrundungen oder abgerundeten Kanten X und/oder Y auch bei den Ausführungsbeispielen gemäß Figur 6 vorgesehen sein können, so dass diese Abrundungen oder abgerundeten Kanten also an den erhabenen Gehäusedeckel-Randabschnitten 18' ausgebildet sind, und zwar jeweils wieder auf der von der Schraube wegweisenden Seite und der der Schraube zugewandt liegenden Seite. Das Gleiche gilt für das Ausführungsbeispiel gemäß Figur 7. Dort könnten jeweils abgerundete Kanten aufeinander zulaufen, da sie an beiden erhabenen Abschnitten 15' und 18' ausgebildet sein können.

Auch bei dieser Variante werden also die erfindungsgemäßen Vorteile entsprechend erzielt.

Bevorzugt ist allerdings die Ausführungsform gemäß dem Ausführungsbeispiel nach den Figuren 1 bis 5, da in diesem Fall als Gehäusedeckel ein plattenförmiges Material, insbesondere ein plattenförmiges Metallteil verwendet werden kann.

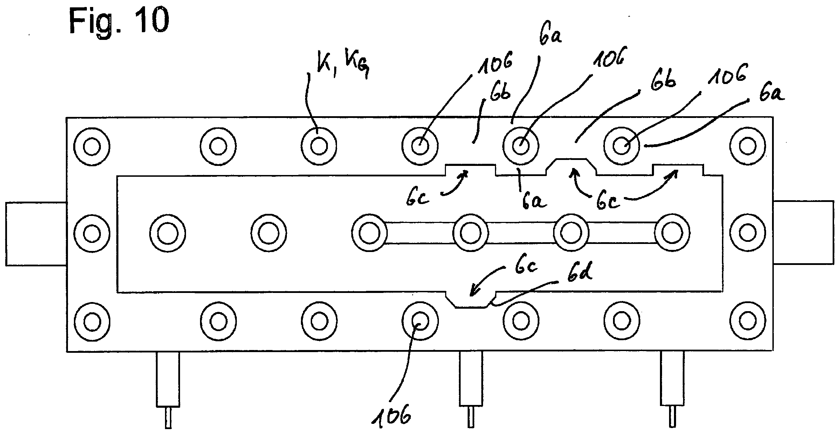

Die erläuterten Gehäusewände 6 des Filters können - wie dargestellt - eine gleiche Wandstärke aufweisen. Im gezeigten Ausführungsbeispiel gemäß Figur 10 ist die Gehäusewand unterschiedlich dick ausgebildet. Jeweils in den Bereichen, in denen die Gewindebohrungen 106 ausgebildet sind, weist die Gehäusewand 6 einen dickeren Materialdurchmesser 6a auf, um die Gewindebohrungen 106 mit entsprechendem Innendurchmesser aufnehmen zu können. Die dazwischen befindlichen Gehäusewandabschnitte 6b sind mit demgegenüber dünnerem Materialabschnitt, also mit dünnerem Wandabschnitt, gebildet. Dies kann beispielsweise dadurch realisiert werden, dass bevorzugt an den Innenseiten der Gehäusewände entsprechende und in der Regel senkrecht zur Bodenfläche verlaufende nutförmige Vertiefungen 6c ausgebildet sind, die einen geeigneten Querschnitt aufweisen können, beispielsweise als rechteckförmige Nut oder als mit gegenüberliegenden Abflachungen 6d versehene walmdachförmige Nut. Beliebige Abwandlungen sind hierbei möglich. Des Weiteren kann an diesen Stellen (wo die Gewindebohrungen 106 in den Wandabschnitten mit größerer Dicke ausgebildet sind) ein definierter Kontakt in Form eines ringförmigen Wulstes geschaffen werden, der jeweils den erwähnten erhabenen Abschnitt 15' bildet. Die dazwischen befindlichen Wandabschnitte 6b sind dann, wie erwähnt, mit einer dünneren Wandstärke dimensioniert. Dies ist aber für die Realisierung der erläuterten Ausführungsbeispiele nicht zwingend notwendig.

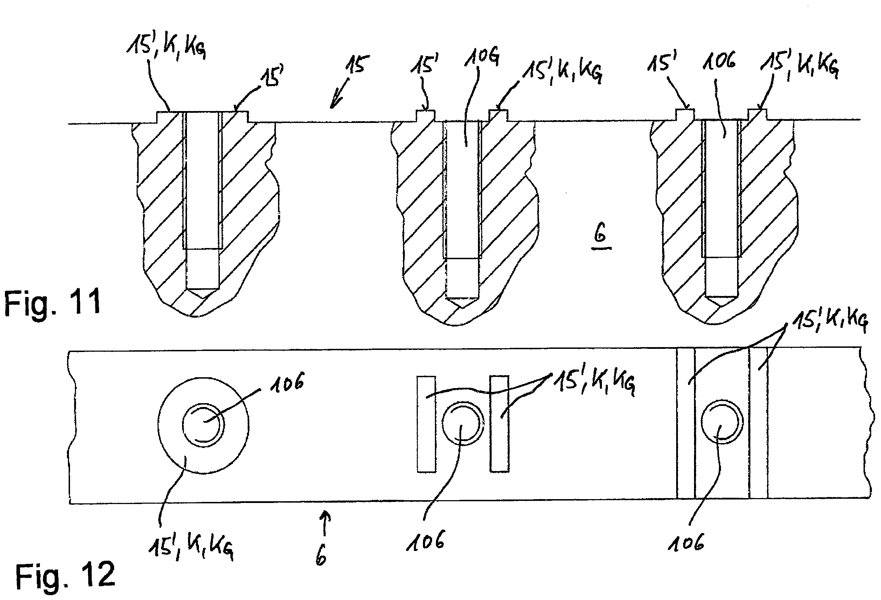

Nachfolgend wird noch auf eine schematische Abwandlung anhand von Figur 11 in vertikaler Schnittdarstellung parallel zu den Bohrlöchern in den Gehäusewänden und hinsichtlich Figur 12 in Form einer Draufsicht auf die Gehäusewände und/oder eine Unterseitenansicht auf den Rand 18, 21 des Gehäuseunterdeckels verwiesen.

In Figur 11 und in der entsprechenden Draufsicht gemäß Figur 11 sind drei leicht unterschiedliche Varianten nebeneinander liegend gezeigt.

Bei dem Ausführungsbeispiel gemäß Figur 11 und 12 links liegend ist ein entsprechender erhabener Gehäusewandabschnitt 15' ausgebildet, der die entsprechende Bohrung 106 in der Gehäusewand 6 scheiben- oder tellerförmig umgibt, also ringförmig gestaltet ist.

Bei der in Figur 11 und 12 in der Mitte liegenden Variante ist der erhabene Abschnitt 15' stegförmig gestaltet, weist im gezeigten Ausführungsbeispiel also in Draufsicht beispielsweise eine rechteckige Grundform auf (allgemein n-polygonal), wobei die beiden länglichen rechteckförmigen erhabenen Gehäuserandabschnitte 15' in ihrer Längserstreckung quer und insbesondere senkrecht zur Längserstreckung der Gehäusewand ausgerichtet sind. Der eine erhabene stegförmige Abschnitt liegt dabei links und der andere rechts in Längsrichtung der Gehäusewand versetzt, so dass dazwischenliegend zwischen diesem Paar von erhabenen steg- oder rechteckförmigen Gehäuse-Randabschnitten 15' die entsprechende Bohrung 106 in der Gehäusewand aufgenommen ist. Die vertikale Schnittdarstellung ist dabei in Figur 11 in der Mitte wiedergegeben.

Die Variante in Figur 12 rechts liegend entspricht dabei weitgehend der Variante gemäß Figuren 11 und 12 in der Mitte liegend, mit dem Unterschied, dass sich die stegförmigen Erhebungen 15' bei der Variante gemäß Figuren 11 und 12 rechts liegend über die gesamte Breite (Dicke) der Gehäusewand 6 erstrecken, wohingegen sich die stegförmigen Erhebungen 15' der der Variante gemäß Figuren 11 und 12 in der Mitte liegend nur über eine Teilbreite der Gehäusewand stärker erstrecken, vorzugsweise aber symmetrisch zu einer Mittelebene der Gehäusewand angeordnet sind, damit die von den Schrauben eingeleiteten Kräfte symmetrisch auf diesen erhabenen Gehäuse-Randabschnitten 15' ansetzen können.

Abweichend von der zeichnerischen Darstellung könnten die stegförmigen erhabenen Gehäuse-Randabschnitte 15' aber auch in Draufsicht von Figur 12 verdreht um das Bohrloch 106 angeordnet sein, grundsätzlich in einem beliebigen Winkel. Möglich wäre auch eine Anordnung, bei der die Längserstreckung der einzelnen steg- oder rechteckförmigen erhabenen Gehäuse-Randabschnitte 15' in Längsrichtung der jeweiligen Gehäusewand zu liegen kommen. Hier sind beliebige Abwandlungen möglich, insbesondere auch hinsichtlich der Flächenform der erhabenen Gehäuse-Randabschnitte 15', die nicht zwingend rechteckförmig sein müssen.

Die anhand von Figuren 11 und 12 gezeigten Varianten und Möglichkeiten sowie erörterten Abwandlungen gelten gleichermaßen auch für erhabene Gehäusedeckel-Randabschnitte 18'. Denn auch die anhand der anderen Ausführungsbeispiele erläuterten erhabenen Gehäusedeckel-Randabschnitte 18' können gleichermaßen die anhand von Figuren 8 und 9 erläuterten abgerundeten Kanten X und/oder Y aufweisen, wie aber auch die anhand der Figuren 11 und 12 beschriebenen Ausgestaltungen in Lochscheibenform, Stegform etc.. Beschränkungen bestehen insoweit nicht. Dabei kann also aufgrund der erörterten abgerundeten Kanten X und/oder Y allgemein auch von wulstförmigen erhabenen Gehäuse- und/oder Gehäusedeckel-Randabschnitten gesprochen werden.

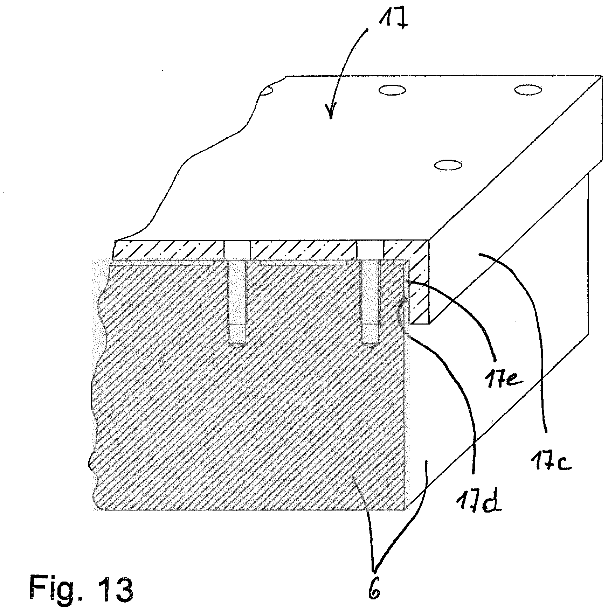

Nachfolgend wird noch auf Figur 13 Bezug genommen, die eine Darstellung eines abgewandelten Ausführungsbeispiels zeigt. In dieser Darstellung ist die vordere Seitenwand des Gehäuses im Vertikalschnitt dargestellt, und zwar in einer Ebene, in der das Zentrum der Schrauben zu liegen kommt.

Daraus ist zu ersehen, dass der Deckel nicht plattenförmig gestaltet ist, sondern mit einem umlaufenden Gehäusedeckelrand 17c versehen sein kann, der auch als umlaufender Gehäusedeckelflansch 17c bezeichnet werden kann. Anders als die in den anderen Ausführungsbeispielen erläuterte Gehäusedeckelwand 17b, die am umlaufenden Rand des Gehäuses aufliegt, ist der anhand von Figur 13 gezeigte umlaufende Gehäusedeckelrand oder Gehäusedeckelflansch 17c so ausgebildet, dass er die Gehäusewände bevorzugt außenliegend in einer Teilhöhe übergreift. Dabei ist die Ausbildung bevorzugt derart, dass die der Gehäusewand 6 benachbart liegende Unter- oder Innenseite 17d im Abstand zur Außenwandfläche der außenliegenden Seite der Gehäusewand 6 liegt, hier also ein Abstandsraum 17e gebildet ist. Durch den erwähnten umlaufenden Gehäusedeckelrand oder -flansch 17c werden die erwähnten Spalte 27, 127, 227 nach außen hin überdeckt, sind also von außen her bei aufgesetztem Deckel nicht sichtbar.

Der Abstandsraum 17d kann eine Breite aufweisen, die in etwa der Größenordnung der Tiefe bzw. Höhe der Spalte 27, 127, 227 entspricht. Die entsprechende Spalthöhe 27, 127, 227 wie aber auch die Spaltbreite 17d kann unterschiedliche Maße aufweisen. Sie ist zumindest so groß, dass in den entsprechend erläuterten Bereichen ein galvanischer Kontakt ausgeschlossen ist.

Die Spalthöhe kann dabei abweichend von den Zeichnungen sogar größere Werte annehmen, insbesondere dann, wenn die Höhe des die Spalte überdeckenden Gehäusedeckelrandes bzw. Gehäusedeckelflansches 17c nochmals größer ist als die entsprechende Spalthöhe.

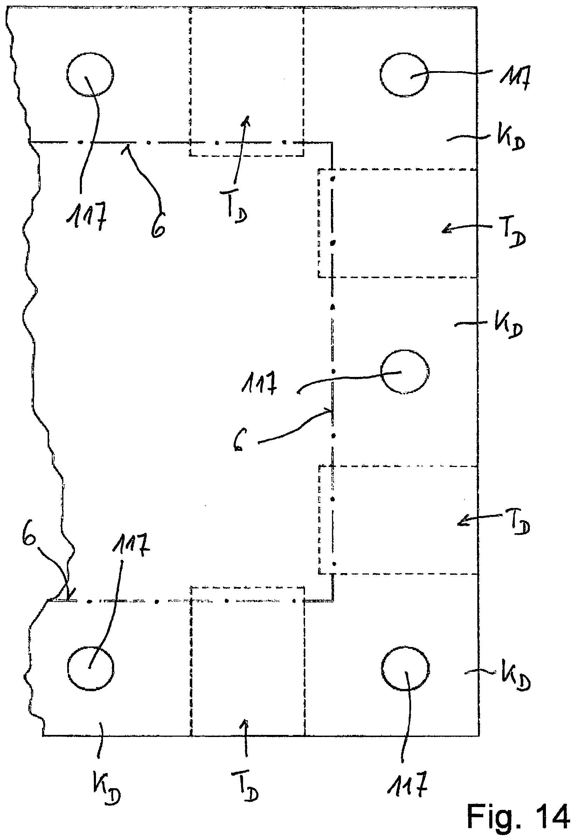

Nachfolgend wird auf das Ausführungsbeispiel gemäß Figur 14 Bezug genommen, in welchem ausschnittsweise eine Unteransicht des Gehäusedeckels 17 wiedergegeben ist.

Wie daraus zu ersehen ist, ist in dem Bereich des Gehäuserandes 18 in Umlaufrichtung des Gehäuserandes folgend jeweils ein Kontaktbereich oder Kontaktabschnitt K und ein Trennbereich oder Trennabschnitt T vorgesehen. Insoweit wird auch von einem Gehäusedeckel-Kontaktbereich K_{D} und einem Gehäuse-Trennbereich T_{G} gesprochen.

In diesem Ausführungsbeispiel besteht der Deckel beispielsweise aus einem dielektrischen also elektrisch nichtleitenden Körper und ist vorzugsweise auf seiner Außen- und seiner Innen- oder Unterseite und an seinem umlaufenden stirnseitigen die Ober- und die Unterseite verbindenden Rand bevorzugt mit einer metallischen Schicht überzogen. Diese metallisch leitfähige Schicht ist auch in den erwähnten Gehäusedeckel-Kontaktbereichen K_{D} ausgebildet. In diesen Bereichen sind dann auch die Bohrungen 117 im Gehäusedeckel 17 vorgesehen.
Die dazwischen liegenden Gehäusedeckel-Trennbereiche- oder Trennabschnitte T_{D} sind in diesem Fall von einer elektrisch leitfähigen Schicht befreit, so dass in diesem Bereich das Dielektrikum oder eine andere Isolierschicht frei zu liegen kommt, die möglicherweise dann nur durch die metallische Schicht auf der Außenseite des aus einem elektrisch nichtleitfähigen Material gebildeten Gehäusedeckels überdeckt ist.
Setzt man einen derartigen Gehäusedeckel auf ein entsprechendes Gehäuse zum Beispiel mit einem eben umlaufenden Gehäuserand 15 einer Gehäusewand 6 auf (in Figur 14 strichpunktiert dargestellt), der beispielsweise vollflächig mit einer elektrisch leitfähigen Schicht überzogen sein kann (wobei die Gehäusewand insgesamt einschließlich ihres Randes auch aus einem elektrisch leitfähigen Material bestehen kann), so werden auch an dem Gehäuserand aufeinanderfolgend jeweils Kontaktstellen K_{G} und elektrische Trennstellen T_{G} gebildet. Die Kontaktstellen K_{G} am Gehäuserand 15 werden dadurch gebildet, dass hier die elektrisch leitfähigen Kontaktabschnitte K_{D} des Gehäusedeckels aufliegen, hier also die galvanische Kontaktierung bewirken. In diesem Bereich sind dann die Schraubverbindungen vorgesehen. Die elektrischen Trennstellen T_{G} am Gehäuserand 15 werden - auch wenn der Gehäuserand 15 elektrisch leitfähig ist - dadurch gebildet, dass hierzu benachbart die von einer elektrisch leitfähigen Schicht befreiten Bereiche am Gehäusedeckel, insbesondere an der Gehäusedeckel-Unterseite ausgebildet sind. Hier werden also kontaktfreie Bereiche gebildet, in denen kein galvanischer Kontakt vorgesehen oder möglich ist.

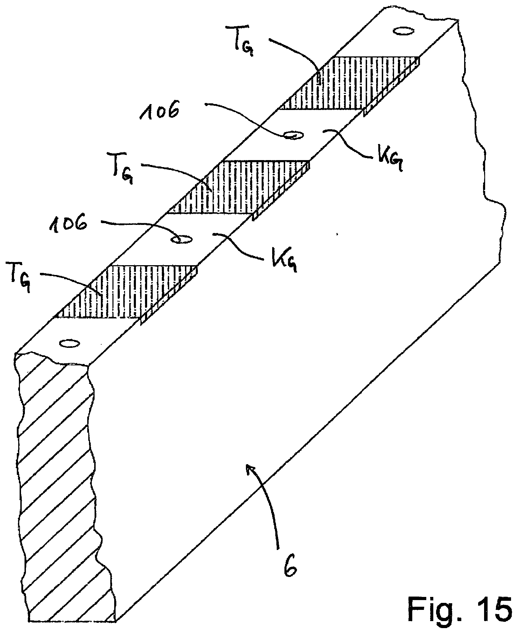

Das Prinzip kann auch umgekehrt ausgebildet sein. Möglich ist beispielsweise, dass das Gehäuse 3 ebenfalls aus einem Dielektrikum oder allgemein nichtleitenden Material oder Kunststoff, beispielsweise aus einem Leiterplattenmaterial (Platinenmaterial) besteht, wobei das Gehäuse 3 an seiner Innenfläche und vorzugsweise auch an seiner Außenfläche wie an seinem obenliegenden, dem Gehäusedeckel 17 zugewandt liegenden Gehäuserand 15 mit einer elektrisch leitfähigen Schicht überzogen ist, einschließlich den Gehäuse-Kontaktabschnitten K_{G}. Zwischen diesen Abschnitten können zur Bildung der Gehäuse-Trennstellen T_{G} zusätzlich die dielektrischen, also die aus nichtleitfähigen Materialien bestehenden Wandabschnitte von einer elektrisch leitfähigen Schicht befreit sind oder eine derartige elektrisch leitfähige Schicht ist dort von Hause aus nicht vorgesehen. Auf einen derart ausgebildeten Gehäuserand kann dann ein Gehäusedeckel aufgesetzt werden, der an seinem auf dem Gehäuserand aufgesetzten umlaufenden Randbereich gegebenenfalls vollflächig leitfähig ist, also eine in einer gemeinsamen Ebene umlaufende elektrisch leitfähige Schicht aufweist. Denn galvanisch wirksame Kontaktabschnitte K werden nur dort ausgebildet, wo die am Gehäuserand vorgesehenen Kontaktabschnitte K_{G} in mechanischem Kontakt bei aufgelegtem Gehäusedeckel treten. Dort, wo am Gehäuserand die elektrisch leitfähigen Schichten entfernt sind und das elektrisch nichtleitfähige Material freiliegt, werden die zwischen dem Gehäusedeckel und dem Gehäuse wirksamen Trennabschnitte T ausgebildet, also die kontaktfreien Abschnitte, in denen eine galvanische Kontaktierung sicher vermieden ist. Dieses Beispiel ist anhand von Figur 15 schematisch erläutert.

Im zuletzt genannten Fall bietet sich ferner an, die von einer elektrisch leitfähigen Schicht befreite Trennstelle T_{G} am Gehäuserand 15 nicht nur an der einen zum Deckel zugewandt liegenden Seite des Gehäuserandes 15 zu befreien, sondern in zumindest einer minimalen Höhe auch noch auf der Innen- und der Außen-Seitenwand 6S.

Das anhand von Figuren 14 und 15 erläuterte Prinzip kann auch gleichzeitig verwirklicht werden. In diesem Fall sollten bevorzugt die Lage und die Größe der Kontaktstellen K, also der Kontaktabschnitte K_{D} am Gehäusedeckel sowie K_{G} am Gehäuserand als auch die Trennstellen T, d.h. die deckelseitigen Trennstellen T_{D} wie die gehäuseseitigen Trennstellen T_{G} am Gehäuserand 15 bezüglich ihrer relativen Lage zueinander und bezüglich ihrer Erstreckungsgröße so aufeinander abgestimmt sein, dass die Kontaktstellen K_{D} an dem Gehäusedeckel 17 in montierter Position deckungsgleich oder zumindest überlappend zu den elektrisch leitfähigen Kontaktabschnitten K_{G} am Gehäuse 3, d.h. am Gehäuserand 15 zu liegen kommen. Dadurch ist auch sichergestellt, dass die entsprechenden Trennstellen T_{D} ebenso wie die Trennstellen T_{G} jeweils zwischen den vorstehenden Kontaktabschnitten benachbart zueinander zu liegen kommen. Diese Ausführungsform entspricht insoweit von ihrer funktionellen Ausgestaltung dem Ausführungsbeispiel gemäß Figur 7. Die vorstehend erläuterte Variante gemäß Figur 14 entspricht demgegenüber in funktioneller Hinsicht dem Ausführungsbeispiel nach Figur 6, wohingegen das Ausführungsbeispiel nach Figur 15 in funktioneller Hinsicht mit dem Ausführungsbeispiel nach Figur 5 vergleichbar ist.

Schließlich soll auch noch erwähnt werden, dass es grundsätzlich möglich wäre an den gewünschten Trennstellen zwischen den Abständen, an denen die Schraubverbindungen ausgebildet sind, eine an sich vorhandene elektrisch leitfähige Kontaktschicht durch Anbringung eines Isolierfilmes oder einer Isolierschicht in einen galvanischen Trennbereich oder Trennabschnitt umzubilden. Diese Trennschichten können sowohl an den entsprechenden Stellen als Deckelunterseite wie an dem umlaufenden Rand des Gehäuses gegebenenfalls einschließlich eines gewissen Seitenwandabschnittes 6s ausgebildet sein. Diese Trennschicht kann sowohl am Deckel als auch am Gehäuserand realisiert sein.

Die bevorzugte Länge der Spalte oder die bevorzugte Länge der definierten Kontakte zwischen Gehäusedeckel und Gehäuse hängt bevorzugt von der Betriebsfrequenz ab, für die das Gehäuse eingesetzt wird. Bevorzugt soll dabei die Spaltlänge bzw. die Kontaktlänge kleiner als λ und insbesondere kleiner als λ/2 bezogen auf die mittlere Betriebsfrequenz sein. Bevorzugt sind die entsprechenden Werte für die Spaltlänge und die Kontaktlänge bezogen auf die mittlere Betriebsfrequenz kleiner als λ/3, λ/4, λ/5, λ/6, λ/7, λ/8, λ/9, λ/10 und kleiner.

Umgekehrt soll die betreffende Spaltlänge bevorzugt größer als 1/40 oder insbesondere größer als 1/30 der Wellenlänge der mittleren Betriebsfrequenz sein. Die bevorzugten Werte für die Kontaktlänge sind größer als 1/80 oder insbesondere größer als 1/70 der Wellenlänge der mittleren Betriebsfrequenz. Die bevorzugten Eckwerte bezüglich der Spaltlänge und der Kontaktlänge können aus den beiden nachfolgenden Tabellen entnommen werden. Dabei sind in der letzten Spalte für die angegebenen Bandbereiche bevorzugte Einzelwerte für die Spalt- und die Kontaktlänge angegeben.

| **Spaltlänge** | | | | | | |
|---|---|---|---|---|---|---|
| | | | | | | |
| Band | mittlere Betriebsfrequenz | λ | λ/2 | λ/40 | λ/30 | Ist |
| MHz | MHz | mm | mm | mm | mm | mm |
| | | | | | | |
| 700/800 | 750 | 400 | 200 | 10 | 13,3 | 24 |
| 800/900 | 800 | 375 | 188 | 9,4 | 12,5 | 24 |
| 1800/2200 | 2000 | 150 | 75 | 3,75 | 5 | 12 |

| **Kontaktlänge** | | | | | | |
|---|---|---|---|---|---|---|
| | | | | | | |
| Band | mittlere Betriebsfrequenz | λ | λ/2 | λ/80 | λ/70 | Ist |
| MHz | MHz | mm | mm | mm | mm | mm |
| | | | | | | |
| 700/800 | 750 | 400 | 200 | 5 | 5,7 | 5 |
| 800/900 | 800 | 375 | 188 | 4,7 | 5,4 | 5 |
| 1800/2200 | 2000 | 150 | 75 | 1,9 | 2,1 | 5 |

Die vorstehend beschriebene Erfindung zeichnet sich durch eine Vielzahl von Merkmalen, vor allem auch bevorzugten Merkmalen aus. Nachfolgend sind einige bevorzugte Merkmale angegeben, wie sie insbesondere auch mit Merkmalen aus zumindest einem der Ansprüche 1 bis 15 in Zusammenhang stehend verwirklicht sein können. Dabei handelst es sich um folgende Merkmale, wonach
- die Spalte (27, 127, 227) zwischen Gehäusedeckel (17) und Gehäuserand (15) von einem Gehäusedeckel-rand oder Gehäusedeckelflansch (17c) überdeckt ist,
- die Höhe des Gehäusedeckelrandes oder Gehäusedeckelflansches (17c) größer ist als die Höhe der Spalte (27, 127, 227),
- die Höhe des Gehäusedeckelrandes oder Gehäusedeckelflansches (17c) zumindest dem 1,5-fachen, vorzugsweise dem 2-fachen, 2,5-fachen oder 3-fachen der Materialdicke des Gehäusedeckels (17) entspricht und vorzugsweise kleiner ist als das 6-fache, 5-fache oder 4-fache der Dicke des Gehäusedeckels (17),
- die Höhe der Spalte (27, 127, 227) kleiner ist als die 2-fache Dicke des Gehäusedeckels (17), insbesondere kleiner ist als die Dicke des Gehäusedeckels (17) oder kleiner ist als das 0,9-fache, 0,8-fache, 0,7-fache, 0,6-fache, 0,5-fache, 0,4-fache, 0,3-fache oder das 0,2-fache der Dicke des Gehäusedeckels (17),
- zwischen dem Gehäusedeckelrand oder Gehäusedeckelflansch (17c) und der Außenseite der Gehäusewände (6) ein Abstandsraum (17e) gebildet ist, und
- die Spalten (27, 127, 227) mit einem elektrisch nichtleitfähigen Material oder Dielektrikum ausgefüllt sind.

## Patentansprüche

1. Hochfrequenzdichtes Gehäuse, insbesondere hochfrequenzdichtes Filtergehäuse, mit folgenden Merkmalen:
- mit einem Gehäuse (3) mit einem Gehäuseboden (5) und einer sich vom Gehäuseboden (5) erhebenden Gehäusewand (6) und mit einem Gehäusedeckel (17),
- auf einem an der Gehäusewand (6) des Gehäuses (3) ausgebildeten Gehäuserand (15) ist der Gehäusedeckel (17) unter Bildung eines Gesamtgehäuses (2) aufgesetzt,
- das Gehäuse (3) und/oder der Gehäusedeckel (17) bestehen aus einem elektrisch leitfähigen Material oder aus einem mit einer elektrisch leitfähigen Schicht überzogenen dielektrischen Material,
- der Gehäusedeckel (17) weist mehrere Befestigungsbohrungen (117) auf, die mit entsprechenden Bohrungen (106) in der Gehäusewand (6) fluchten,
- der Gehäusedeckel (17) ist an dem Gehäuse (3) mittels mehrerer Schraubverbindungen (25) befestigt oder befestigbar, wobei die Schraubverbindungen (25) Befestigungsschrauben (19) umfassen, die die Befestigungsbohrungen (117) im Gehäusedeckel (17) durchsetzen und in die dazu axial fluchtende Bohrungen (109) in der Gehäusewand (6) des Gehäuses (3) eingreifen,
- das hochfrequenzdichte Gehäuse ist so ausgelegt, dass im montierten Zustand der Gehäusedeckel (17) und das Gehäuse (3) galvanisch kontaktiert sind,
- zwischen dem Gehäusedeckel (17) und dem Gehäuse (3) sind mehrere versetzt zueinander angeordnete Kontaktabschnitte (K; K_{G}; K_{D}) gebildet oder vorgesehen,
- zwischen den Kontaktabschnitten (K; K_{G}; K_{D}) sind Trennabschnitte (T; T_{G}; T_{D}) gebildet oder vorgesehen, in deren Bereichen der Gehäusedeckel (17) und das Gehäuse (3) galvanisch getrennt sind,
- die Kontaktabschnitte (K) sind an dem Gehäuserand (15) des Gehäuses (3) in Form von Gehäuse-Kontaktabschnitten (K_{G}) ausgebildet, die aufeinanderfolgende und versetzt zueinander liegende und in Richtung Gehäusedeckel (17) vorstehende Gehäuse-Randabschnitten (15') umfassen,
- die Trennabschnitte (T) sind in Form von Gehäuse-Trennabschnitten (T_{G}) ausgebildet, die gegenüber dem Gehäusedeckel (17) vertiefte oder zurückversetzte Gehäuse-Randabschnitte (15") umfassen, die zwischen den vorstehenden Gehäuse-Randabschnitten (15') angeordnet sind,
- im Bereich der vertieften oder zurückversetzten Gehäuse-Randabschnitte (15") zwischen der Gehäusewand (6) und dem Gehäusedeckel (17) ist ein eine galvanische Trennung bewirkender Spalt (27) gebildet,
- die Schraubverbindungen (25) sind in den Kontaktabschnitten (K; K_{G}; K_{D}) vorgesehen, in deren Bereichen der Gehäusedeckel (17) mit dem Gehäuse (3) galvanisch kontaktiert ist,
**gekennzeichnet dadurch, dass**
- der Gehäusedeckel (17) mit dem Gehäuse (3) ausschließlich in diesen Kontaktabschnitten (K; K_{G}; K_{D}) mittels jeweils einer einzigen der Schraubverbindungen (25) fest verbunden ist.

2. Hochfrequenzdichtes Gehäuse nach Anspruch 1, **dadurch gekennzeichnet, dass** der Gehäusedeckel (17) mit einem oder mit mehreren in einer Ebene liegenden elektrisch leitfähigen Kontaktbereichen versehen ist, worüber der Gehäusedeckel (17) auf den Gehäuse-Kontaktabschnitten (K_{G}) aufliegt und in diesen Gehäuse-Kontaktabschnitten (K_{G}) galvanisch mit dem Gehäuse (3) kontaktiert ist.

3. Hochfrequenzdichtes Gehäuse, insbesondere hochfrequenzdichtes Filtergehäuse, mit folgenden Merkmalen:
- mit einem Gehäuse (3) mit einem Gehäuseboden (5) und einer sich vom Gehäuseboden (5) erhebenden Gehäusewand (6) und mit einem Gehäusedeckel (17),
- auf einem an der Gehäusewand (6) des Gehäuses (3) ausgebildeten Gehäuserand (15) ist der Gehäusedeckel (17) unter Bildung eines Gesamtgehäuses (2) aufgesetzt,
- das Gehäuse (3) und/oder der Gehäusedeckel (17) bestehen aus einem elektrisch leitfähigen Material oder aus einem mit einer elektrisch leitfähigen Schicht überzogenen dielektrischen Material,
- der Gehäusedeckel (17) weist mehrere Befestigungsbohrungen (117) auf, die mit entsprechenden Bohrungen (106) in der Gehäusewand (6) fluchten,
- der Gehäusedeckel (17) ist an dem Gehäuse (3) mittels mehrerer Schraubverbindungen (25) befestigt oder befestigbar, wobei die Schraubverbindungen (25) Befestigungsschrauben (19) umfassen, die die Befestigungsbohrungen (117) im Gehäusedeckel (17) durchsetzen und in die dazu axial fluchtende Bohrungen (109) in der Gehäusewand (6) des Gehäuses (3) eingreifen,
- das hochfrequenzdichte Gehäuse ist so ausgelegt, dass im montierten Zustand der Gehäusedeckel (17) und das Gehäuse (3) galvanisch kontaktiert sind,
- zwischen dem Gehäusedeckel (17) und dem Gehäuse (3) sind mehrere versetzt zueinander angeordnete Kontaktabschnitte (K; K_{G}; K_{D}) gebildet oder vorgesehen,
- zwischen den Kontaktabschnitten (K; K_{G}; K_{D}) sind Trennabschnitte (T; T_{G}; T_{D}) gebildet oder vorgesehen, in deren Bereichen der Gehäusedeckel (17) und das Gehäuse (3) galvanisch getrennt sind,
- die Kontaktabschnitte (K) sind an dem Gehäusedeckel (17) in Form von Gehäusedeckel-Kontaktabschnitten (K_{D}) ausgebildet, die aufeinanderfolgende und versetzt zueinander liegende und in Richtung Gehäuse (3) vorstehende Gehäusedeckel-Abschnitte (18') umfassen,
- die Trennabschnitte (T) sind in Form von Gehäusedeckel-Trennabschnitten (T_{D}) ausgebildet, die gegenüber dem Gehäuse (3) vertiefte oder zurückversetzte Gehäusedeckel-Abschnitte (18") umfassen, die zwischen den vorstehenden Gehäusedeckel-Abschnitten (18') angeordnet sind,
- im Bereich der vertieften oder zurückversetzten Gehäusedeckel-Abschnitte (18") zwischen der Gehäusewand (6) und dem Gehäusedeckel (17) ist ein eine galvanische Trennung bewirkender Spalt (127) gebildet ,
- die Schraubverbindungen (25) sind in den Kontaktabschnitten (K; K_{G}; K_{D}) vorgesehen, in deren Bereichen der Gehäusedeckel (17) mit dem Gehäuse (3) galvanisch kontaktiert ist,
**gekennzeichnet dadurch, dass**
- der Gehäusedeckel (17) mit dem Gehäuse (3) ausschließlich in diesen Kontaktabschnitten (K; K_{G}; K_{D}) mittels der Schraubverbindungen (25) fest verbunden ist.

4. Hochfrequenzdichtes Gehäuse nach Anspruch 3, **dadurchgekennzeichnet,** dass der Gehäuserand (15) mit einem oder mit mehreren in einer Ebene liegenden elektrisch leitfähigen Kontaktbereichen versehen ist, auf denen der Gehäusedeckel (17) mit seinen an den vorstehenden Gehäusedeckel-Abschniten (18') ausgebildeten Gehäusedeckel-Kontaktabschnitten (K_{D}) aufliegt und in diesen Gehäusedeckel-Kontaktabschnitten (K_{D}) galvanisch mit dem Gehäuse (3) kontaktiert ist.

5. Hochfrequenzdichtes Gehäuse nach Anspruch 1 oder 3, **dadurch gekennzeichnet, dass** sowohl am Gehäuserand (15) in Richtung Gehäusedeckel (17) vorstehende und versetzt zueinander liegende Gehäuse-Randabschnitte (15') und dazwischenliegend vertiefte oder zurückversetzte Gehäuse-Randabschnitte (15") wie auch am Gehäusedeckel (17) in Richtung Gehäuse (3) vorstehende Gehäusedeckel-Abschnitte (18') und dazwischenliegend vertiefte oder zurückversetzte Gehäusedeckel-Abschnitte (18") ausgebildet sind, und dass bei auf das Gehäuse (3) aufgesetztem Gehäusedeckel (17) die erhabenen oder vorstehenden Gehäusedeckel-Abschnitte (18') auf den erhabenen oder vorstehenden Gehäuserandabschnitten (15') zumindest teilweise überlappend aufeinanderliegen und in diesem Bereich miteinander galvanisch kontaktiert sind, wohingegen zwischen den zurückversetzten oder vertieft ausgebildeten Gehäuse-Randabschnitten (15") und Gehäusedeckel-Abschnitten (18") Trennabschnitte (T; T_{D}, T_{G}) unter Ausbildung eines Spaltes (227) vorgesehen sind, in denen der Gehäusedeckel (17) vom Gehäuse (3) galvanisch getrennt ist.

6. Hochfrequenzdichtes Gehäuse nach einem der Ansprüche 1 bis 5, **dadurch gekennzeichnet, dass** die Kontaktabschnitte (K; K_{G}, K_{D}) ringförmig, quadratisch, rechteckförmig, stegförmig oder n-polygonalförmig, insbesondere nach Art eines regelmäßigen n-Polygonals, gebildet sind.

7. Hochfrequenzdichtes Gehäuse nach einem der Ansprüche 1 bis 6, **dadurch gekennzeichnet, dass** die Gehäuse-Kontaktabschnitte (K_{G}; 15') und/oder die Gehäusedeckel-Kontaktabschnitte (K_{D}; 18') mit Ecken oder Kanten (X; Y) versehen sind, die abgerundet sind.

8. Hochfrequenzdichtes Gehäuse nach einem der Ansprüche 2 bis 7, **dadurch gekennzeichnet, dass** die Spalte (27, 127, 227) zwischen dem Gehäuse (3) und dem Gehäusedeckel (17) im Bereich der vertieften Gehäuse-Randabschnitte (15") und/oder der vertieften Gehäusedeckel-Abschnitte (18") und/oder die Länge der Kontaktabschnitte (K_{G}; 15'; K_{D}; 18') eine Länge aufweisen, die kleiner ist als die Wellenlänge der mittleren Betriebsfrequenz insbesondere kleiner ist als die halbe Wellenlänge der mittleren Betriebsfrequenz.

9. Hochfrequenzdichtes Gehäuse nach einem der Ansprüche 2 bis 8, **dadurch gekennzeichnet, dass** die Länge der vertieften oder zurückversetzten Gehäuse-Randabschnitte (15") und/oder die Länge der vertieften oder zurückversetzten Gehäusedeckel-Abschnitte (18") und/oder die Länge der Kontaktabschnitte (K_{G}; 15'; K_{D}; 18') eine Länge aufweisen, welche größer ist als 1/40 der Wellenlänge der mittleren Betriebsfrequenz, insbesondere größer als 1/30 der Wellenlänge der mittleren Betriebsfrequenz.

10. Hochfrequenzdichtes Gehäuse nach einem der Ansprüche 2 bis 9, **dadurch gekennzeichnet, dass** die Länge der erhabenen Gehäuse-Randabschnitte (15') und/oder der erhabenen Gehäusedeckel-Abschnitte (18') kleiner als die Wellenlänge der mittleren Betriebsfrequenz ist, insbesondere kleiner als die halbe Wellenlänge der mittleren Betriebsfrequenz ist.

11. Hochfrequenzdichtes Gehäuse nach einem der Ansprüche 1 bis 10, **dadurch gekennzeichnet, dass** die Länge der erhabenen Gehäuse-Randabschnitte (15') und/oder der erhabenen Gehäusedeckel-Abschnitte (18') größer als 1/80 der Wellenlänge der mittleren Betriebsfrequenz ist, insbesondere größer als 1/70 der Wellenlänge der mittleren Betriebsfrequenz ist.

12. Hochfrequenzdichtes Gehäuse nach einem der Ansprüche 1 bis 4, **dadurch gekennzeichnet, dass** der Gehäusedeckel (17) aus einem nichtleitenden Material oder einem Platinenmaterial besteht, welches mit einer elektrisch leitfähigen Schicht überzogen ist, wobei die Gehäusedeckel-Trennabschnitte (T_{D}) ohne elektrisch leitfähige Schicht ausgebildet oder eine elektrisch leitfähige Schicht entfernt ist.

13. Hochfrequenzdichtes Gehäuse nach Anspruch 1 oder 12, **dadurch gekennzeichnet, dass** das Gehäuse (3) einschließlich des Gehäuserandes (15) aus einem nichtleitenden Material oder Platinenmaterial gebildet ist und mit einer elektrisch leitfähigen Schicht überzogen ist, wobei in den Gehäuse-Trennabschnitten (T_{G}) der Gehäuserand (15) ohne elektrisch leitfähige Schicht ausgebildet oder eine elektrisch leitfähige Schicht in diesem Bereich entfernt ist.

14. Hochfrequenzdichtes Gehäuse nach einem der Ansprüche 1 bis 13, **dadurch gekennzeichnet, dass** der Gehäusedeckel (17) und/oder das Gehäuse (3) mit seinem Gehäuserand (15) aus einem elektrisch leitfähigen Material besteht oder mit einem elektrisch leitfähigen Material überzogen ist, und dass die Gehäusedeckel-Trennabschnitte (T_{D}) und/oder die Gehäuse-Trennabschnitte (T_{G}) mittels eines elektrisch nicht leitfähigen Überzuges gebildet sind.

15. Hochfrequenzdichtes Gehäuse nach einem der vorhergehenden Ansprüche, **dadurch gekennzeichnet, dass** das hochfrequenzdichte Gesamtgehäuse (2) ein hochfrequenzdichtes Filtergehäuse bildet, insbesondere unter Ausbildung von koaxialen Hohlraumresonatoren.

## Claims

1. High-frequency-proof housing, in particular high-frequency-proof filter housing, having the following features:
- comprising a housing (3) comprising a housing base (5) and a housing wall (6) rising from the housing base (5) and comprising a housing cover (17),
- the housing cover (17) is positioned on a housing edge (15) formed on the housing wall (6) of the housing (3) to form a complete housing (2),
- the housing (3) and/or the housing cover (17) consist of an electrically conductive material or of a dielectric material coated with an electrically conductive layer,
- the housing cover (17) has a plurality of fastening holes (117), which are aligned with corresponding holes (106) in the housing wall (6),
- the housing cover (17) is fastened or fastenable to the housing (3) by means of a plurality of screw connections (25), the screw connections (25) comprising fastening screws (19) which penetrate the fastening holes (117) in the housing cover (17) and engage in the holes (109) axially aligned therewith in the housing wall (6) of the housing (3),
- the high-frequency sealed housing is designed in such a way that the housing cover (17) and the housing (3) are galvanically contacted in the mounted state,
- between the housing cover (17) and the housing (3), a plurality of contact portions (K; K_{G}; K_{D}) arranged in a mutually offset manner are formed or provided,
- between the contact portions (K; K_{G}; K_{D}), isolation portions (T; T_{G}; T_{D}) are formed or provided, in the regions of which the housing cover (17) and the housing (3) are galvanically isolated,
- the contact portions (K) are formed on the housing edge (15) of the housing (3) in the form of mutually offset housing contact portions (K_{G}) which are positioned in succession and comprise housing edge portions (15') protruding towards the housing cover (17),
- the isolation portions (T) are in the form of housing isolation portions (T_{G}) which comprise housing edge portions (15") that are depressed or recessed with respect to the housing cover (17) and arranged between the protruding housing edge portions (15'),
- a gap (27) which brings about galvanic isolation is formed between the housing wall (6) and the housing cover (17) in the region of the depressed or recessed housing edge portions (15"),
- the screw connections (25) are provided in the contact portions (K; K_{G}; K_{D}) in the regions of which the housing cover (17) is galvanically contacted with the housing (3),
**characterised in that**
- the housing cover (17) is rigidly connected to the housing (3) by means of a single screw connections (25) only in these contact portions (K; K_{G}; K_{D}).

2. High-frequency-proof housing according to claim 1, **characterised in that** the housing cover (17) is provided with one or more electrically conductive contact regions positioned in a plane, via which the housing cover (17) rests on the housing contact portions (K_{G}) and is galvanically contacted with the housing (3) in these housing contact portions (K_{G}),.

3. High-frequency-proof housing, in particular a high-frequency-proof filter housing, comprising the following features:
- comprising a housing (3) comprising a housing base (5) and a housing wall (6) rising from the housing base (5) and comprising a housing cover (17),
- the housing cover (17) is positioned on a housing edge (15) formed on the housing wall (6) of the housing (3) to form a complete housing (2),
- the housing (3) and/or the housing cover (17) consist of an electrically conductive material or of a dielectric material coated with an electrically conductive layer,
- the housing cover (17) has a plurality of fastening holes (117), which are aligned with corresponding holes (106) in the housing wall (6),
- the housing cover (17) is fastened or fastenable to the housing (3) by means of a plurality of screw connections (25), the screw connections (25) comprising fastening screws (19) which penetrate the fastening holes (117) in the housing cover (17) and engage in the holes (109) axially aligned therewith in the housing wall (6) of the housing (3),
- in the mounted state the housing cover (17) and the housing (3) are galvanically contacted,
- between the housing cover (17) and the housing (3), a plurality of contact portions (K; K_{G}; K_{D}) arranged in a mutually offset manner are formed or provided,
- between the contact portions (K; K_{G}; K_{D}), isolation portions (T; T_{G}; T_{D}) are formed or provided, in the regions of which the housing cover (17) and the housing (3) are galvanically isolated,
- the contact portions (K) are formed on the housing cover (17) in the form of housing cover contact portions (K_{D}), which comprise mutually offset housing cover portions (18') that are positioned in succession and protrude towards the housing (3),
- the isolation portions (T) are formed as housing cover isolation portions (T_{D}) which comprise housing cover portions (18") that are depressed or recessed with respect to the housing (3) and arranged between the protruding housing cover portions (18'),
- a gap (127) which brings about galvanic isolation is formed between the housing wall (6) and the housing cover (17) in the region of the depressed or recessed housing edge portions (18"),
- the screw connections (25) are provided in the contact portions (K; K_{G}; K_{D}) in the regions of which the housing cover (17) is galvanically contacted with the housing (3),
**characterised in that**
- the housing cover (17) is rigidly connected to the housing (3) by means of the screw connections (25) only in these contact portions (K; K_{G}; K_{D}).

4. High-frequency-proof housing according to claim 3, **characterised in that** the housing edge (15) is provided with one or more electrically conductive contact regions that are positioned in a plane and on which the housing cover (17) is positioned by its housing cover contact portions (K_{G}) formed on the protruding housing cover portions (18') and is galvanically contacted with the housing (3) in these housing cover contact portions (K_{G}).

5. High-frequency-proof housing according to either claim 1 or 3, **characterised in that** mutually offset housing edge portions (15') protruding towards the housing cover (17) on the housing edge (15), and depressed or recessed housing edge portions (15") positioned therebetween, as well as housing cover portions (18') protruding towards the housing (3) on the housing cover (17), and depressed or recessed housing cover portions (18") positioned therebetween are formed, and **in that** when the housing cover (17) is positioned on the housing (3) the raised or protruding housing cover portions (18') on the raised or protruding housing edge portions (15') are positioned on top of one another in an overlapping manner at least in part, and are galvanically contacted with one another in this region, whilst isolation portions (T; T_{D}, T_{G}), in which the housing cover (17) is galvanically isolated from the housing (3), are provided between the recessed or depressed housing edge portions (15") and housing cover portions (18"), forming a gap (227).

6. High-frequency-proof housing according to any of claims 1 to 5, **characterised in that** the contact portions (K; K_{G}; K_{D}) are square, rectangular, ridge-shaped or n-gon-shaped, in particular in the manner of a regular n-gon.

7. High-frequency-proof housing according to any of claims 1 to 6, **characterised in that** the housing contact portions (K_{G}; 15') and/or the housing cover contact portions (K_{D}; 18') are provided with corners or edges (X; Y) which are rounded.

8. High-frequency-proof housing according to any of claims 2 to 7, **characterised in that** the gaps (27, 127, 227) between the housing (3) and the housing cover (17) in the region of the depressed housing edge portions (15") and/or the depressed housing cover portions (18") and/or the length of the contact portions (K_{G}; 15'; K_{D}; 18') have a length which is less than the wavelength of the average operating frequency, in particular less than the half-wavelength of the average operating frequency.

9. High-frequency-proof housing according to any of claims 2 to 8, **characterised in that** the length of the depressed or recessed housing edge portions (15") and/or the length of the depressed or recessed housing cover portions (18") and/or the length of the contact portions (K_{G}; 15'; K_{D}; 18') have a length which is greater than 1/40 of the wavelength of the average operating frequency, in particular greater than 1/30 of the wavelength of the average operating frequency.

10. High-frequency-proof housing according to any of claims 2 to 9, **characterised in that** the length of the raised housing edge portions (15') and/or the raised housing cover portions (18') is less than the wavelength of the average operating frequency, in particular less than the half-wavelength of the average operating frequency.

11. High-frequency-proof housing according to any of claims 1 to 10, **characterised in that** the length of the raised housing edge portions (15') and/or the raised housing cover portions (18') is greater than 1/80 of the wavelength of the average operating frequency, in particular greater than 1/70 of the wavelength of the average operating frequency.

12. High-frequency-proof housing according to any of claims 1 to 4, **characterised in that** the housing cover (17) consists of a non-conductive material or a circuit board material which is coated with an electrically conductive layer, the housing cover isolation portions (T_{D}) being formed without an electrically conductive layer or an electrically conductive layer being removed.

13. High-frequency-proof housing according to either claim 1 or claim 12, **characterised in that** the housing (3), including the housing edge (15), is formed of a non-conductive material or circuit board material and coated with an electrically conductive layer, the housing edge (15) being formed without an electrically conductive layer in the housing isolation portions (T_{G}) or an electrically conductive layer being removed in this region.

14. High-frequency-proof housing according to any of claims 1 to 13, **characterised in that** the housing cover (17) and/or the housing edge (15) of the housing (3) consist of an electrically conductive material or are coated with an electrically conductive material, and **in that** the housing cover isolation portions (T_{D}) and/or the housing isolation portions (T_{G}) are formed by means of an electrically non-conductive coating.

15. High-frequency-proof housing according to any of the preceding claims, **characterised in that** the complete high-frequency-proof housing (2) forms a high-frequency-proof filter housing, in particular forming coaxial cavity resonators.

## Revendications

1. Boitier blindé contre les hautes fréquences, notamment boitier filtre blindé contre les hautes fréquences, doté des caractéristiques suivantes :
- doté d'un boitier (3) avec un socle (5) de boitier et une paroi (6) de boitier s'élevant à partir du socle (5) de boitier, et avec un couvercle (17) de boitier,
- le couvercle (17) de boitier est disposé sur un bord (15) de boitier formé sur la paroi (6) de boitier du boitier (3), moyennant la formation d'un boitier complet (2),
- le boitier (3) et/ou le couvercle de boitier (17) sont constitués d'un matériau conducteur électriquement ou d'un matériau diélectrique revêtu d'une couche conductrice électriquement,
- le couvercle (17) de boitier présente plusieurs alésages de fixation (117) qui sont alignés avec les alésages (106) correspondants dans la paroi (6) de boitier,
- le couvercle (17) de boitier est fixé ou peut être fixé sur le boitier (3) au moyen de plusieurs assemblages à vis (25), où les assemblages à vis (25) comprennent des vis de fixation (19) qui traversent les alésages de fixation (117) dans le couvercle (17) de boitier et se mettent en prise dans les alésages (109) alignées axialement à ceux-ci dans la paroi (6) de boitier du boitier (3),
- le boitier blindé contre les hautes fréquences est conçu de manière à ce qu'à l'état monté, le couvercle (17) de boitier et le boitier (3) sont en contact de manière galvanique,
- plusieurs segments de contact (K ; K_{G} ; K_{D}), disposés décalés les uns par rapport aux autres, sont formés ou prévus entre le couvercle (17) de boitier et le boitier (3),
- des segments de séparation (T ; T_{G} ; T_{D}) sont formés ou prévus entre les segments de contact (K ; K_{G} ; K_{D}) dans les zones desquels le couvercle (17) de boitier et le boitier (3) sont séparés de manière galvanique,
- les segments de contact (K) sont conçus sous la forme de segments de contact de boitier (K_{G}) sur le bord (15) de boitier du boitier (3), segments qui comprennent des segments de bord de boitier (15') situés superposés et décalés les uns par rapport aux autres et faisant saillie en direction du couvercle (17) de boitier,
- les segments de séparations (T) sont conçus sous la forme de segments de séparation de boitier (T_{G}) qui comprennent des segments de bord de boitier (15") en contrebas par rapport au couvercle (17) de boitier ou décalés vers l'arrière, qui sont disposés entre les segments de bord de boitier (15') faisant saillie,
- une fente (27), provoquant une séparation galvanique, est formée dans la zone des segments de bord de boitier (15") en contrebas ou décalés vers l'arrière entre la paroi (6) de boitier et le couvercle (17) de boitier,
- les assemblages à vis (25) sont prévus dans les segments de contact (K ; K_{G} ; K_{D}), dans les zones desquels le couvercle (17) de boitier est en contact de manière galvanique avec le boitier (3),
**caractérisé en ce que**
- le couvercle (17) de boitier est relié solidement avec le boitier (3) exclusivement dans ces segments de contact (K ; K_{G} ; K_{D}) au moyen respectivement d'un seul parmi les assemblages à vis (25).

2. Boitier blindé contre les hautes fréquences selon la revendication 1, **caractérisé en ce que** le couvercle (17) de boitier est muni d'une ou de plusieurs zones de contact conductrices électriquement se situant dans un plan, ce par quoi le couvercle (17) de boitier repose sur les segments de contact de boitier (K_{G}) et est en contact de manière galvanique avec le boitier (3) dans ces segments de contact de boitier (K_{G}).

3. Boitier blindé contre les hautes fréquences, notamment boitier filtre blindé contre les hautes fréquences, avec les caractéristiques suivantes :
- doté d'un boitier (3) avec un socle (5) de boitier et une paroi (6) de boitier s'élevant à partir du socle (5) de boitier, et avec un couvercle (17) de boitier,
- le couvercle (17) de boitier est disposé sur un bord (15) de boitier formé sur la paroi (6) de boitier du boitier (3), moyennant la formation d'un boitier complet (2),
- le boitier (3) et/ou le couvercle de boitier (17) sont constitués d'un matériau conducteur électriquement ou d'un matériau diélectrique revêtu d'une couche conductrice électriquement,
- le couvercle (17) de boitier présente plusieurs alésages de fixation (117) qui sont alignés avec les alésages (106) correspondants dans la paroi (6) de boitier,
- le couvercle (17) de boitier est fixé ou peut être fixé sur le boitier (3) au moyen de plusieurs assemblages à vis (25), où les assemblages à vis (25) comprennent des vis de fixation (19) qui traversent les alésages de fixation (117) dans le couvercle (17) de boitier et se mettent en prise dans les alésages (109) alignés axialement à ceux-ci dans la paroi (6) de boitier du boitier (3),
- le boitier blindé contre les hautes fréquences est conçu de manière à ce qu'à l'état monté, le couvercle (17) de boitier et le boitier (3) sont en contact de manière galvanique,
- plusieurs segments de contact (K ; K_{G} ; K_{D}) disposés décalés les uns par rapport aux autres sont formés ou prévus entre le couvercle (17) de boitier et le boitier (3),
- des segments de séparation (T ; T_{G} ; T_{D}) sont formés ou prévus entre les segments de contact (K ; K_{G} ; K_{D}) dans les zones desquels le couvercle (17) de boitier et le boitier (3) sont séparés de manière galvanique,
- les segments de contact (K) sont conçus sous la forme de segments de contact de boitier (K_{D}) sur le couvercle (17) de boitier, segments qui comprennent des segments de couvercle de boitier (18') situés superposés et décalés les uns par rapport aux autres et faisant saillie en direction du boitier (3),
- les segments de séparations (T) sont conçus sous la forme de segments de séparation de boitier (T_{D}) qui comprennent des segments couvercle de boitier (18") en contrebas par rapport au boitier (3) ou décalés vers l'arrière, qui sont disposés entre les segments de couvercle de boitier (18') faisant saillie,
- une fente (27) provoquant une séparation galvanique est formée dans la zone des segments de couvercle de boitier (18") en contrebas ou décalés vers l'arrière entre la paroi (6) de boitier et le couvercle (17) de boitier,
- les assemblages à vis (25) sont prévus dans les segments de contact (K ; K_{G} ; K_{D}), dans les zones desquels le couvercle (17) de boitier est en contact de manière galvanique avec le boitier (3),
**caractérisé en ce que**
- le couvercle (17) de boitier est relié solidement avec le boitier (3) exclusivement dans ces segments de contact (K ; K_{G} ; K_{D}) au moyen respectivement d'un seul parmi les assemblages à vis (25).

4. Boitier blindé contre les hautes fréquences selon la revendication 3, **caractérisé en ce que** le bord (15) de boitier est muni d'une ou de plusieurs zones de contact conductrices électriquement se situant dans un plan, sur lesquelles repose le couvercle (17) de boitier avec ses segments de contact de couvercle (K_{D}) formés sur les segments de couvercle de boitier (18') protubérants et est en contact dans ces segments de contact de couvercle (K_{D}) de boitier avec le boitier (3).

5. Boitier blindé contre les hautes fréquences selon la revendication 1 ou la revendication 3, **caractérisé en ce qu'**à la fois des segments de bord de boitier (15') situés en protubérance sur le bord (15) de boitier en direction du couvercle (17) de boitier et décalés les uns par rapport aux autres et des segments de bord de boitier (15") en contrebas ou décalés vers l'arrière se situant entre ceux-ci, et également des segments de couvercle de boitier (18') protubérants sur le couvercle (17) de boitier en direction du boitier (3) et des segments de couvercle de boitier (18") en contrebas ou décalés vers l'arrière se situant entre ceux-ci, sont formés, et que, lorsque le couvercle (17) de boitier est disposé sur le boitier (3), les segments de couvercle de boitier (18') s'élevant ou étant protubérants et les segments de bord de boitier (15') s'élevant ou étant protubérants sont disposés les uns au-dessus des autres en se superposant au moins partiellement et sont en contact de manière galvanique les uns avec les autres dans cette zone, par contre, des segments de séparation (T ; T_{D} ; T_{G}), dans lesquels le couvercle (17) de boitier est séparé de manière galvanique du boitier (3), sont prévus entre les segments de bord de boitier (15") décalés vers l'arrière ou formés en contrebas et des segments de couvercle de boitier (18"), moyennant la formation d'une fente (227).

6. Boitier blindé contre les hautes fréquences selon l'une des revendications 1 à 5, **caractérisé en ce que** les segments de contact (K ; K_{G} ; K_{D}) sont conçus en forme d'anneaux, de forme carrée, de forme rectangulaire, en forme de barre ou de forme n-polygonale, notamment, selon un n-polygone régulier.

7. Boitier blindé contre les hautes fréquences selon l'une des revendications 1 à 6, **caractérisé en ce que** les segments de contact de boitier (K_{G} ; 15') et/ou les segments de contact de couvercle de boitier (K_{D} ; 18') sont munis d'angles ou d'arêtes (X ; Y) qui sont arrondis.

8. Boitier blindé contre les hautes fréquences selon l'une des revendications 2 à 7, **caractérisé en ce que** les fentes (27, 127, 227) entre le boitier (3) et le couvercle (17) de boitier dans la zone des segments de bord de boitier (15") et/ou des segments de couvercle de boitier (18") en contrebas, et/ou la longueur des segments de contact (K_{G} ; 15' ; K_{D} ; 18'), présentent une longueur qui est inférieure à la longueur d'onde de la fréquence de fonctionnement moyenne, notamment, est inférieure à la moitié de la longueur d'onde de la fréquence de fonctionnement moyenne.

9. Boitier blindé contre les hautes fréquences selon l'une des revendications 2 à 8, **caractérisé en ce que** la longueur des segments de bord de boitier (15") en contrebas ou décalés vers l'arrière, et/ou la longueur des segments de couvercle de boitier (18") en contrebas ou décalés vers l'arrière, et/ou la longueur des segments de contact (K_{G} ; 15' ; K_{D} ; 18') présentent une longueur qui est supérieure de 1/40 par rapport à la longueur d'onde de la fréquence de fonctionnement moyenne, notamment supérieure de 1/30 par rapport à la longueur d'onde de la fréquence de fonctionnement moyenne.

10. Boitier blindé contre les hautes fréquences selon l'une des revendications 2 à 9, **caractérisé en ce que** la longueur des segments de bord de boitier (15') s'élevant, et/ou la longueur des segments de couvercle de boitier (18') s'élevant est inférieure à la longueur d'onde de la fréquence de fonctionnement moyenne, notamment, est inférieure à la moitié de la longueur d'onde de la fréquence de fonctionnement moyenne.

11. Boitier blindé contre les hautes fréquences selon l'une des revendications 1 à 10, **caractérisé en ce que** la longueur des segments de bord de boitier (15') s'élevant, et/ou la longueur des segments de couvercle de boitier (18') s'élevant est supérieure de 1/80 à la longueur d'onde de la fréquence de fonctionnement moyenne, notamment, est supérieure de 1/70 à la longueur d'onde de la fréquence de fonctionnement moyenne.

12. Boitier blindé contre les hautes fréquences selon l'une des revendications 1 à 4, **caractérisé en ce que** le couvercle (17) de boitier est constitué d'un matériau non conducteur ou d'un matériau de type platine, lequel est revêtu d'une couche conductrice électriquement, où les segments de couvercle de boitier (T_{D}) sont conçus sans couche conductrice électriquement ou qu'une couche conductrice électriquement est enlevée.

13. Boitier blindé contre les hautes fréquences selon la revendication 1 ou la revendication 12, **caractérisé en ce que** le boitier (3), y compris le bord (15) de boitier, est formé à base d'un matériau non conducteur ou d'un matériau de type platine et est revêtu par une couche conductrice électriquement, où le bord (15) de boitier est conçu sans couche conductrice électriquement dans les segments de séparation de boitier (T_{G}) ou une couche électriquement conductrice est enlevée dans ces zones.

14. Boitier blindé contre les hautes fréquences selon l'une des revendications 1 à 13, **caractérisé en ce que** le couvercle (17) de boitier, et/ou le boitier (3) avec son bord (15) de boitier, est constitué d'un matériau électriquement conducteur et que les segments de séparation de couvercle de boitier (T_{D}) et/ou les segments de séparation de boitier (T_{G}) sont formés au moyen d'un revêtement non conducteur électriquement.

15. Boitier blindé contre les hautes fréquences selon l'une des revendications précédentes, **caractérisé en ce que** le boitier complet (2) blindé contre les hautes fréquences forme un boitier filtre blindé contre les hautes fréquences, notamment, moyennant la formation de résonateurs à cavités coaxiaux.
